(19) **Europäisches Patentamt**
**European Patent Office**
**Office européen des brevets**

(11) **EP 3 791 433 B1**

(12) **EUROPEAN PATENT SPECIFICATION**

(45) Date of publication and mention
of the grant of the patent:
**14.02.2024 Bulletin 2024/07**

(21) Application number: **19724895.8**

(22) Date of filing: **07.05.2019**

(51) International Patent Classification (IPC):
**H10N 30/85** $^{(2023.01)}$ **H10N 30/853** $^{(2023.01)}$

(52) Cooperative Patent Classification (CPC):
**H10N 30/853; H10N 30/1051; H10N 30/8554;
H10N 30/8561**

(86) International application number:
**PCT/GB2019/051255**

(87) International publication number:
**WO 2019/215436 (14.11.2019 Gazette 2019/46)**

(54) **AN ELECTRICAL ELEMENT COMPRISING A MULTILAYER THIN FILM CERAMIC MEMBER, AN
ELECTRICAL COMPONENT COMPRISING THE SAME, AND USES THEREOF**

EIN ELEKTRISCHES ELEMENT MIT EINEM MEHRSCHICHTIGEN
DÜNNFILM-KERAMIK-MITGLIED, EINE ELEKTRISCHE KOMPONENTE MIT DIESEM ELEMENT
UND DIE VERWENDUNGEN DAVON

UN ÉLÉMENT ÉLECTRIQUE COMPRENANT UN ÉLÉMENT DES MULTICOUCHES CÉRAMIQUES
À COUCHES MINCES, UN COMPOSANT ÉLECTRIQUE LE COMPRENANT ET SES UTILISATIONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.05.2018 GB 201807508**

(43) Date of publication of application:
**17.03.2021 Bulletin 2021/11**

(73) Proprietor: **Xaar Technology Limited
Huntingdon, Cambridgeshire PE29 6XX (GB)**

(72) Inventors:
• **MARDILOVICH, Peter
Cambridge, Cambridgeshire CB4 0XR (GB)**

• **KO, Song Won
Cambridge, Cambridgeshire CB4 0XR (GB)**
• **TROLIER-MCKINSTRY, Susan
University Park, PA 16802 (US)**
• **FRAGKIADAKIS, Charalampos
Cambridge, Cambridgeshire CB4 0XR (GB)**
• **ZHU, Wanlin
University Park, PA 16802 (US)**

(74) Representative: **Stott, Michael John et al
Mathys & Squire
The Shard
32 London Bridge Street
London SE1 9SG (GB)**

(56) References cited:
**EP-A1- 3 220 431 GB-A- 2 532 106**

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**Description**

The present invention relates to an electrical element comprising a multilayer thin film ceramic member which is a dielectric exhibiting piezoelectric / electrostrictive properties which make it suitable for use in microelectromechanical systems. In particular, the multilayer thin film ceramic member comprises a layer of doped ceramic material which is positioned relative to the electrodes of the electrical component. The layer of doped ceramic material is doped with: I) one or more transition-metal ions capable of Jahn-Teller distortion of the perovskite ($ABX_3$) crystal structure of the ceramic material and/or one or more non-transition metal ions which have a lower oxidation state and/or one or more transition metal ions which preferentially undergo reduction, compared to the B-site cation of the perovskite ($ABX_3$) crystal structure of the ceramic material. The invention also relates to an electrical component comprising the electrical element and the use of such a doped layer of ceramic material in an electrical element.

Electrical components comprising a thin film ceramic member are utilised in a wide range of applications, including as actuators, sensors, energy harvesting devices and multilayer capacitors. Thin film ceramic members which function as actuator materials are required to generate electric-field induced strains for a wealth of devices including, for instance, mechanical relays, digital cameras, and inkjet printers. The composition and crystal structure of the actuator material are critical to determining the actuator characteristics. Common actuator materials include piezoelectric materials which undergo physical changes in shape when exposed to an external electric field. However, dielectric materials that do not exhibit the piezoelectric effect may also potentially find application as actuators.

In principle, all dielectric materials exhibit electrostriction, which is characterised by a change in shape under the application of an electric field. Electrostriction is caused by displacement of ions in the crystal lattice upon exposure to an external electric field; positive ions being displaced in the direction of the field and negative ions displaced in the opposite direction. This displacement accumulates throughout the bulk material and results in an overall macroscopic strain (elongation or contraction) in the direction of the field.

The critical performance characteristics for an actuator material include the effective piezoelectric coefficient, $d_{33}{}^*$, the temperature dependence of $d_{33}{}^*$ and the long-term stability of $d_{33}{}^*$ in device operation. Another important property of actuator materials is the useable lifetime of the actuator material. There is a continuing demand for further improvement in lifetime, as actuators are required to operate under increasingly severe conditions for certain applications. Such improvements in lifetime are also highly desirable in thin film ceramics employed in other devices, such as those described above.

US 2017/0021624 describes the improvement of actuator lifetime in inkjet printheads by incorporating a passive layer over the top electrode of the actuator component so as to restrain the actuator material near the top electrode with respect to contraction. This arrangement is said to obviate the need for a bias voltage to be applied to the actuator material when not exposed to an actuation voltage, which is believed to reduce power consumption and extend the expected lifetime.

US 8,179,027 describes applying an elastic material, such as a silicone-based material, to cover the actuator of an electronic device. The elastic material is said to inhibit migration of metal ions between the electrodes and through the interposed piezoelectric material via micro-cracks formed therein that otherwise leads to actuator failure. Thus, the application of the coating is said to extend the useable lifetime of the electronic device.

US 2006/055288 describes the incorporation of micro-disturbances into the actuator structure in such a manner that the micro-disturbances provide an area of controllable crack growth, preventing uncontrollable crack growth in other regions of the actuator structure that would otherwise lead to actuator failure.

GB2532106 describes a piezoelectric actuator comprising a multiple piezoelectric layer laminate that has layers that are doped with different dopants and undoped layers.

EP3220431 describes a piezoelectric thin film element suitable for use as an actuator for a droplet deposition head in a droplet deposition apparatus. The piezoelectric thin film element comprises a first electrode, a second electrode and one or more piezoelectric thin films there between wherein the first electrode is a platinum metal electrode.

There remains a need for providing alternative means for improving the useable lifetime of thin film ceramics employed in various electronic devices such as actuators, sensors, energy harvesting devices and multilayer capacitors. The present invention is based on the discovery that providing a particular doped layer of thin film ceramic material within a multilayer thin film ceramic member, and at a particular region over the thickness of the multilayer thin film ceramic member relative to the position of the electrodes in an electrical element, leads to substantial improvements in usable lifetime of the thin film ceramic member in the electrical element.

**SUMMARY**

Thus, in a first aspect, the present invention provides an electrical element for use in microelectromechanical systems according to the independent device claim 1.

The invention further provides the use of a ceramic material having a major proportion of a perovskite ($ABX_3$)

phase according to claim 15.

## BRIEF DESCRIPTION OF THE DRAWINGS

FIGURE 1: shows a cross-sectional view of an electrical component in accordance with an embodiment of the invention operating in the field-down configuration;

FIGURE 2: shows a cross-sectional view of an electrical component in accordance with an embodiment of the invention operating in the field-up configuration;

FIGURE 3: shows a cross-sectional view of an electrical component in accordance with an embodiment of the invention operating in the field-down configuration and comprising three ceramic layers;

FIGURE 4: shows a cross-sectional view of an electrical component in accordance with an embodiment of the invention where a pair of electrodes is provided on a single side of the thin film ceramic member; and

FIGURE 5: shows a top view of an electrical component in accordance with an embodiment of the invention where an interdigitated pair of electrodes is provided on a single side of the thin film ceramic member, each electrode having three electrode fingers.

FIGURE 6: shows a cross-sectional view of an electrical component not forming part of the invention having a doped layer of ceramic material positioned within the centre of a multilayer thin film ceramic member.

It should be noted that the drawings are not to scale and that certain features may be shown with exaggerated sizes so that these are more clearly visible.

## DETAILED DESCRIPTION

It has been found by the inventors that particularly advantageous properties in a multilayer thin film ceramic member intended for use in an electrical element can be obtained by incorporating a doped layer of thin film ceramic material into the multilayer. In addition, it has also been found that the beneficial effects are reliant on ensuring that the doped layer of thin film ceramic material is located at a particular region over the thickness of the thin film ceramic member relative to the location of the electrodes of the electrical element. The invention is compatible with all conceivable electrode configurations, provided that at least first and second electrodes are provided, between which a potential difference may be established and through the thin film ceramic member.

In particular, the inventors have found that constructing the electrical component comprising the multilayer thin film ceramic member in the manner described herein substantially extends the median lifetime ($t_{50}$) of the ceramic member in the electrical element. This is particularly advantageous for: i) extending the useable lifetime (e.g. the median lifetime ($t_{50}$) under electrical field) of the thin film ceramic member of an electrical element; ii) providing greater resilience and stability to electrical elements exposed to severe operating conditions (e.g. high electric field/high voltage); iii) obviating recovery processes that may be available to restore performance in electrical components whose performance is progressively degrading upon continuative usage; iv) reducing waste associated with failed electrical components that cannot be restored; and v) increasing commercial viability of certain ceramic materials for use in electronic elements which previously would have resulted in unacceptable lifetime, particularly where operated with the electric field direction pointing towards the doped layer of thin film ceramic material into the multilayer, as described in more detail below.

Reference herein to the "median lifetime ($t_{50}$)" in regard to the thin film ceramic member is intended to refer to the duration over which samples of the thin film ceramic member may be exposed to an electric field as a component of an electrical element as described herein, under highly accelerated lifetime test (HALT) conditions, as detailed below, before 50 % of the tested samples fail. Failure in this context may be characterised, for instance, based on the leakage current value of the thin film ceramic member exceeding a threshold value of 100 times the minimum leakage current density detected for the thin film ceramic member of the electrical element following continuous exposure to the electric field. Leakage current may, for instance, be measured using a Keithley picoammeter, which may also act as a direct current (DC) source, and Labview based software may be used to monitor leakage current across different samples versus time. Samples may for instance be placed in a 24-pin dual in-line package (DIP) which is readily available and top electrodes may be wire bonded to the contact pads of the package with metal (e.g. Au) wire. The median lifetime ($t_{50}$) of samples of the thin film ceramic material may then be determined using highly accelerated lifetime tests (HALTs) which expose the ceramic material samples to direct current (DC) electric field (e.g. 300 kV/cm) at high temperature (e.g. 200 °C).

Reference herein to the "higher potential electrode" and the "lower potential electrode" in the context of the first and second electrodes describes the relative difference in potential energy between the two electrodes which means a potential difference exists between first and second electrodes during operation. It is therefore possible that both of the first and second electrodes have positive or negative potential, provided there is a potential difference established between the two electrodes. One of the electrodes may be the ground electrode. As will be appreciated by the skilled person, the direction of the electric field is from the higher potential electrode to the lower potential electrode.

The layers of ceramic material used to form the multilayer thin film ceramic member used in accordance with the present invention are crystalline and comprise a major proportion of a perovskite crystallographic phase (i.e. above 50 vol.%). Such ceramic materials exhibit piezoelectric and/or electrostriction properties making them useful in microelectromechanical systems (MEMS) applications discussed herein. Such ceramic materials include conventional piezoelectric materials as well as relaxor ferroelectric materials.

The lattice dimensions of the dominant crystalline phase, and the physical and chemical properties of the ceramic material, are functions of composition. The lattice symmetry may change within said composition range by uniform distortion of the structure as the composition changes. In preferred embodiments, the layers of ceramic material which form the multilayer thin film ceramic member comprise at least 70 vol.%, more preferably at least 80 vol.%, even more preferably at least 90 vol.%, yet more preferably at least 95 vol.% of a perovskite crystallographic phase. Most preferably, the layers of ceramic material which form the multilayer thin film ceramic member are substantially homogeneous (i.e. phase pure), having only a perovskite crystalline phase.

In accordance with the present invention, the thin film ceramic member used in the electrical element of the present invention is formed of a plurality of layers of ceramic material (i.e. the thin film ceramic member is multilayered). In particular, the thin film ceramic member includes first and second layers of thin film ceramic material. As discussed in more detail below, the first and second layers of ceramic material may each be formed from several overlaid sub-layers resulting, for instance, from multiple rounds of a thin film deposition process.

The first layer employed in the thin film ceramic member is doped with: I) one or more transition metal ions capable of Jahn-Teller distortion of the perovskite ($ABX_3$) crystal structure of the ceramic material and/or II) one or more non-transition metal ions which have a lower oxidation state and/or one or more transition metal ions which preferentially undergo reduction, compared to the B-site cation of the perovskite ($ABX_3$) crystal structure of the ceramic material.

With regard to the first of the above two groups of ions, Jahn-Teller distortion is often witnessed in octahedral complexes and describes the net change in the energy levels of the octahedral orbitals ($t_g$ and $e_g$), thereby removing the orbital and electronic degeneracies, leading to distortion along one of the molecular axes and lowering of the overall energy of the complex. Distortion typically takes the form of elongation of the bonds but may also lead to contraction. Metal ions which are capable of eliciting Jahn-Teller distortion in perovskites are known and are, for example, described in: Lufaso, Michael W. and Woodward, Patrick M., "Jahn-Teller Distortions, Cation Ordering and Octahedral Tilting in Perovskites" (2004), Chemistry Faculty Publications. 3. Specific examples of metal ions that are capable of Jahn-Teller distortion of the perovskite ($ABX_3$) crystal structure include Ag, Cr, Cu, Mn and Re ions. Specific examples of such ions include $Ag^{2+}$, $Cr^{2+}$, $Cu^{2+}$, and $Mn^{3+}$. As will be appreciated, combinations of the above-mentioned ions, including ions of different elements, may be employed in connection with the present invention.

Another group of metal ions that may be used in the doped first layer of the thin film ceramic material are those that are non-transition metal ions that have a lower oxidation state or transition metal ions which preferentially undergo reduction, compared to the B-site cation of the perovskite ($ABX_3$) crystal structure of the ceramic material. In the perovskite structure, "$ABX_3$", 'A' and 'B' are cations of different sizes, and X is an anion that bonds to both cations. As will be appreciated by the skilled person, it is understood that multiple cations can occupy the A- or B-sites of the perovskite structure. As an example, in the well-known perovskite, lead zirconate titanate (PZT), the A-site cation corresponds to $Pb^{2+}$, the B-site cations correspond to $Ti^{4+}$ and $Zr^{4+}$, and X corresponds to $O^{2-}$. In accordance with the present invention, non-transition metal ions which have a lower oxidation state or transition metal ions which preferentially reduce in preference to the B-site cation (i.e. in preference to $Ti^{4+}$ and $Zr^{4+}$ in this example) may be employed as a dopant metal ion in the first ceramic layer in accordance with the present invention. As will be appreciated, where the metal ion preferentially reduces over the B-site cation, this requires the metal element to have multiple oxidation states. Moreover, as will also be appreciated, in that case the dopant metal ions must also be provided in an oxidation state that is capable of undergoing reduction to a lower oxidation state. Non-transition metal ions in this group include alkali metal ions (Na, K, Cs, Rb ions), alkaline earth metal ions (Sr and Ba ions) and post-transition metal ions. Transition metal ions in this group include Co, Cr, Cu, Fe, Mn, Mo, Ni and V ions. Specific examples of ions that are capable of undergoing reduction include $Co^{3+}$, $Cr^{3+}$, $Cr^{6+}$, $Cu^{2+}$, $Fe^{3+}$, $Mn^{3+}$, $Mn^{4+}$, $Mo^{3+}$, $Mo^{4+}$, $Mo^{5+}$, $Mo^{6+}$, $Ni^{2+}$, $Ni^{3+}$, $Ni^{4+}$, $V^{3+}$, $V^{4+}$, and $V^{5+}$. As will be appreciated, combinations of the above-mentioned ions, including ions of different elements, may be employed in connection with the present invention.

The transition metal ions that may be employed as the dopant metal ions in the first layer of ceramic material are: i) capable of Jahn-Teller distortions of the perovskite ($ABX_3$) crystal structure; ii) preferentially undergo reduction over the B-site cation of the perovskite ($ABX_3$) crystal structure of the ceramic material; or iii) have both characteristics of i) and ii). Preferred examples of such metal ions having both of these characteristics include Cr, Cu and Mn ions, preferably those selected from $Cr^{2+}$, $Cu^{2+}$, and $Mn^{3+}$.

Without being bound by any particular theory, the dopant metal ions described above are believed to modify the properties of the ceramic material in which they are contained to confer the beneficial properties associated with the invention. Thin film ceramic materials comprising a major proportion of a perovskite crystallographic phase in accordance with the present invention can have vacancies of the component X of the perovskite ($ABX_3$). When the thin film ceramic material is based on $ABO_3$ systems, for example, the ceramic material may have oxygen vacancies, which may be formed under a reducing atmosphere and during operation of an electrical element comprising such a material. Oxygen vacancies have effective positive charge and they are mobile; under electric field there is tendency for migration towards the electrode that is kept at a lower potential with respect to the other (i.e. towards the high potential electrode), which can adversely affect performance. In particular, such migration of oxygen vacancies is considered to be responsible for degradation of a piezoelectric thin film through time dependent resistance degradation. Although it is possible to recover the performance of the thin film ceramic in certain situations (e.g. by eliminating oxygen vacancies, for instance, by means of a recovery anneal under oxygen), it is undesirable for such recovery processes to be required to maintain performance.

Acceptor dopants are known to generate further oxygen vacancies in the thin film ceramic materials that may be used in accordance with the present invention. Thus, use of such acceptor dopants would generally be expected to have a negative impact on the lifetime of the thin film ceramic material containing them. However, it is believed that the particular dopants used in accordance with the present invention, whilst increasing the population of oxygen vacancies, exert an overall beneficial effect by locally reducing the mobility of oxygen vacancies in the perovskite structure ($ABX_3$) of the ceramic material. For example, Jahn-Teller ions may preferentially attract X vacancies, resulting in a reduced migration of such vacancies. Thus, the presence of the dopant in accordance with the present invention is believed to overcome the problems associated with oxygen vacancy migration that otherwise contributes to mechanical/electrical fatigue and failure of the ceramic material.

Alternatively, or additionally, it has also been found that B-site cations of the perovskite structure that have undergone reduction (i.e. a decrease in oxidation state) have been found by the inventors to be present in degraded ceramic materials. It is believed that by including dopant transition metal ions in the first layer of ceramic material that preferentially undergo reduction in favour of such B-site cations, the median lifetime ($t_{50}$) may be extended. Such preference for reduction can be readily assessed by the skilled person on the basis of a comparison of the electron affinities of the particular B-site cation and the dopant metal ion, as well as the stability of the reduced dopant ion produced following reduction. Electron affinities may, for instance, be computed using density function theory and Coupled Cluster Single-double and triple (CCSD(T)) approaches. They can also be measured experimentally by routine methods. As an example, $Ti^{3+}$ ions have been found to be prevalent in degraded perovskite ceramic materials originally comprising $Ti^{4+}$ ions at the B-site of the perovskite crystal structure (e.g. as in the case of PZT). Including dopant one or more metal ions in the first layer of ceramic material that preferentially undergo reduction in favour of such ions, for example $Mn^{3+}$ or $Mn^{4+}$ ions which preferentially undergo reduction to $Mn^{2+}$ and $Mn^{3+}$ respectively, means that the population of $Ti^{4+}$ ions in the ceramic material is not appreciably affected. In turn, median lifetime ($t_{50}$) of the ceramic member has been found to be extended.

A similar effect in terms of extending median lifetime ($t_{50}$) may also be observed where non-transition metal ions having a lower oxidation state than the B-site cation are used as dopants, since they also may lower the incidence of, or prevent, reduction of the B-site cation. Examples of such non-transition dopant metal ions include. alkali metal ions (Na, K, Cs, Rb ions), alkaline earth metal ions (Sr and Ba ions) and post-transition metal ions.

Thus, in another aspect, the present invention also provides a use of a ceramic material doped with: I) one or more transition metal ions capable of Jahn-Teller distortion of the perovskite ($ABX_3$) crystal structure of the ceramic material and/or II) one or more non-transition metal ions which have a lower oxidation state, and/or one or more transition metal ions which preferentially undergo reduction, compared to the B-site cation of the perovskite ($ABX_3$) crystal structure of the ceramic material for increasing the median lifetime ($t_{50}$) of an electrical element by incorporating the doped ceramic material as a layer in a multilayer thin film ceramic member which is disposed adjacent first and/or second electrodes of the electrical element, such that a potential difference may be established between the first and second electrodes and through the thin film ceramic member. Specific examples of the one or more transition metal ions include ions of Ag, Co, Cr, Cu, Fe, Mn, Mo, Ni, Re, V and combinations thereof. The electrical element may be as defined herein, such that the first layer of thin film ceramic material corresponds to the doped ceramic material referred to above.

In yet a further aspect, the present invention also provides an electrical element for use in microelectromechanical systems comprising:

a first layer of ceramic material doped with: I) one or more transition metal ions capable of Jahn-Teller distortion of the perovskite ($ABX_3$) crystal structure of the ceramic material and/or II) one or more non-transition metal ions which either have a lower oxidation state and/or one or more transition metal ions which preferentially undergo reduction, compared to the B-site cation of the perovskite ($ABX_3$) crystal structure of the ceramic material; and
a second layer of ceramic material not doped with any of the one or more metal ions as defined for the first layer of ceramic material; and

wherein at least the first layer of ceramic material, preferably all layers of the ceramic member, comprise one or more titanium ions occupying the B-site of the perovskite crystal structure ($ABX_3$) (for example, in the form of the $Ti^{4+}$ ion.

As the doping in the first layer of thin film ceramic material has a generally negative impact upon the piezoelectric / electrostrictive properties of the thin film ceramic material, in order to maintain the overall piezoelectric / electrostrictive performance of the thin film ceramic member, a second layer of thin film ceramic material is included which is not doped with any of the one or more ions described above with which the first layer of ceramic material is doped. Moreover, it has been surprisingly found that the combination of these layers can be advantageously employed so as to access the full benefit in terms of piezoelectric / electrostrictive performance associated with the thin film ceramic member whilst substantially extending its useable lifetime within an electrical component.

No additional layers of material (including for example, non-ceramic, polymeric layers) are located between the first layer of the ceramic member and the electrode(s). As described herein before, the configuration of thin film ceramic member and the electrodes in the electrical component is important for achieving the benefits of the invention. The electrical element may have an electrode configuration in which the thin film ceramic member is interposed between first and second electrodes. Alternatively, it may have an electrode configuration in which the first and second electrodes are provided on one of the first or second side of the thin film ceramic member, for example, as an adjacent or interdigitated pair of electrodes. However, the structure of thin film ceramic member, and the location of the first layer within the multilayer ceramic member, depends upon the particular arrangement of the electrodes.

In embodiments where the first and second electrodes are interposed by the thin film ceramic member, the first layer of thin film material is positioned based on the direction of the electric field between the electrodes. In particular, in order to obtain the benefit of the invention in this electrode configuration, the first layer of thin film material comprising the dopant is disposed adjacent to the electrode to which the electric field is directed (i.e. the low potential electrode). In such an arrangement, the first layer of thin film ceramic material interposes the low potential electrode and the second layer of thin film ceramic material, and in turn the second layer of thin film ceramic material interposes the high potential electrode and the first layer of thin film ceramic material.

In embodiments where the first and second electrodes are provided on one of the first or second side of the thin film ceramic member, the first layer of thin film material is positioned based on proximity to the electrodes. In particular, in order to obtain the benefit of the invention in this electrode configuration, the first layer of thin film material comprising the dopant is disposed adjacent to the electrodes. In such an arrangement, the first layer of thin film ceramic material interposes the electrodes and the second layer of thin film ceramic material. Where the first and second electrodes are provided on one of the first or second side of the thin film ceramic member, first and second electrodes may be an adjacent pair or preferably interdigitated, more preferably wherein the first and second interdigitated electrodes each comprises a plurality of electrode fingers.

In other embodiments, the ceramic member may include a third layer of ceramic material which is arranged over the thickness of the ceramic member so as to be disposed adjacent the second layer of ceramic material; the second layer of ceramic material interposing the first and third layers of ceramic material. The third layer of ceramic material may be as defined for the doped first layer of ceramic material (and therefore does not correspond merely to another sub-layer of the second layer of ceramic material as discussed in more detail below). Thus, when a third layer of ceramic material is present, the second layer of ceramic material interposes two doped layers (i.e. the first and third layers of ceramic material). As will be appreciated, where the ceramic member comprises a third layer as defined above, and where the ceramic member interposes the first and second electrodes, both first and second electrodes may each be in contact with a doped layer of ceramic material, in the form of one of the first or third dopant layers. Nevertheless, as described hereinbefore, in order to achieve the benefits of the invention where the ceramic member interposes the first and second electrodes, it has been found only to be necessary for the first doped layer of ceramic material to be in contact with the one of the first and second electrodes which is the lower potential electrode. However, having first and third doped layers as described herein can have certain additional advantages where the ceramic member interposes the first and second electrodes. In particular, in this arrangement, the direction of the electric field may be inverted (i.e. changed between "field up" and "field down" configuration as described in more detail below) without consequence; either the first or third doped layer of material will always be in contact with the lower potential electrode so as to ensure the benefits of the invention are achieved. This arrangement is thus particularly advantageous for extending median lifetime ($t_{50}$) where it is desirable to be able to freely switch the direction of the electric field applied to the electrical element.

In another aspect, the present invention also provides an electrical component comprising at least one electrical element as described herein and further comprising a substrate layer upon which the at least one electrical element is arranged. Where the electrical component comprises an electrical element which includes an electrode configuration where the thin film ceramic member interposes the electrodes, then first and second electrodes can be notionally considered to be top or bottom electrodes depending on their position relative to the location of the substrate (the bottom electrode being adjacent to the substrate). In such an arrangement, the bottom electrode interposes the substrate and the thin film ceramic member and the top electrode is disposed adjacent to the opposing side of the thin film ceramic member to the bottom electrode.

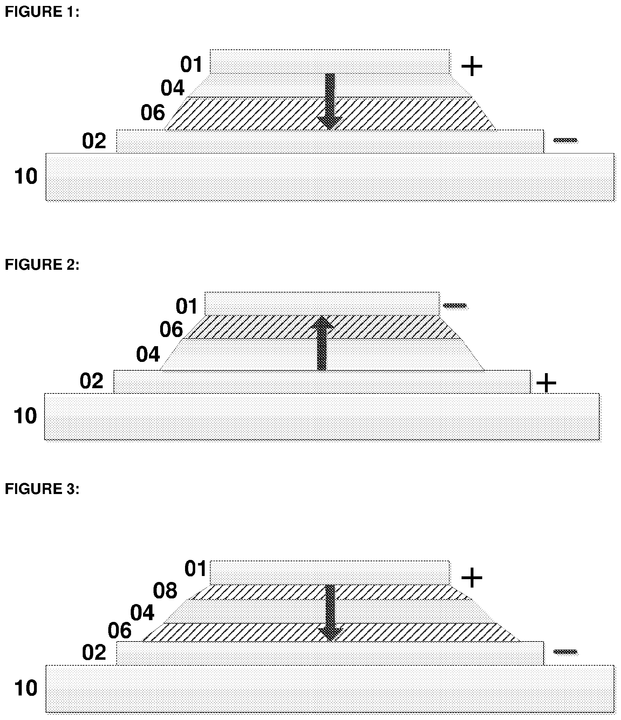

Where the electrical components include top and bottom electrodes, then the electrical component may be operated in "field-up" or "field-down" configurations. Reference in that regard is made to Figures 1 and 2. Figure 1 shows a cross-sectional view of an electrical component in accordance with an embodiment of the invention operating in the field-down configuration. In the field-down configuration, the direction of the electric field (shown by the arrow) is from the top electrode (01) to the bottom electrode (02) (i.e. the top electrode is the high potential electrode and the bottom electrode is the low potential electrode), and the bottom electrode (02) rests on a substrate (10). In accordance with the invention, the first layer of doped thin film ceramic material (06) is disposed adjacent the bottom (low potential) electrode, when operation is in the field-down configuration, whilst the second layer of thin film ceramic material (04) is disposed adjacent the top electrode.

In contrast, Figure 2 shows a cross-sectional view of an electrical component in accordance with an embodiment of the invention operating in the field-up configuration. In the field-up configuration, the direction of the electric field (shown by the arrow) is from the bottom electrode (02), resting on substrate (10), to the top electrode (01) (i.e. the bottom electrode is the high potential electrode and the top electrode is the low potential electrode). In accordance with the invention, the first layer of doped thin film ceramic material (06) is deposited adjacent the top (low potential) electrode (01), when operation is in the field-up configuration, whilst the second layer of thin film ceramic material (04) is disposed adjacent the bottom (high potential) electrode (02).

Figure 3 shows a cross-sectional view of an electrical component in accordance with another embodiment of the invention operating in the field-down configuration. In particular, the direction of the electric field (shown by the arrow) is from the top electrode (01) to the bottom electrode (02), resting on substrate (10) (i.e. the top electrode is the higher potential electrode and the bottom electrode is the lower potential electrode). In contrast with the embodiment depicted in Figure 1, the embodiment depicted in Figure 3 includes a third layer of ceramic material (08), in addition to a first layer of ceramic material (06) and a second layer of ceramic material (04). The third layer of ceramic material (08) is disposed adjacent to the top electrode (i.e. the higher potential electrode in this configuration) and is doped in the same manner as in the first layer of ceramic material (06). This embodiment achieves the same benefits in terms of extending median lifetime ($t_{50}$) in substantially the same manner as the embodiment depicted in Figure 1 comprising only first and second layers of ceramic material. This is because, in both embodiments according to Figures 1 and 3, the first layer of ceramic material is in contact with the bottom electrode (02), which is the lower potential electrode in these field-down configurations.

Although Figure 3 shows operation in the field-down configuration, the direction of the electric field may be inverted (i.e. so as to operate in the field-up configuration) whilst still achieving the benefits of the invention. This is because one of the first or third doped layers of material will always be in contact with the lower potential electrode (in which case what was notionally the "first" and "third" layers in the field-down configuration becomes the "third" and "first" layers in the field-up configuration, respectively). The structure of Figure 3 is thus particularly advantageous for extending median lifetime ($t_{50}$) where it is desirable to be able to freely switch the direction of the electric field applied to the electrical element.

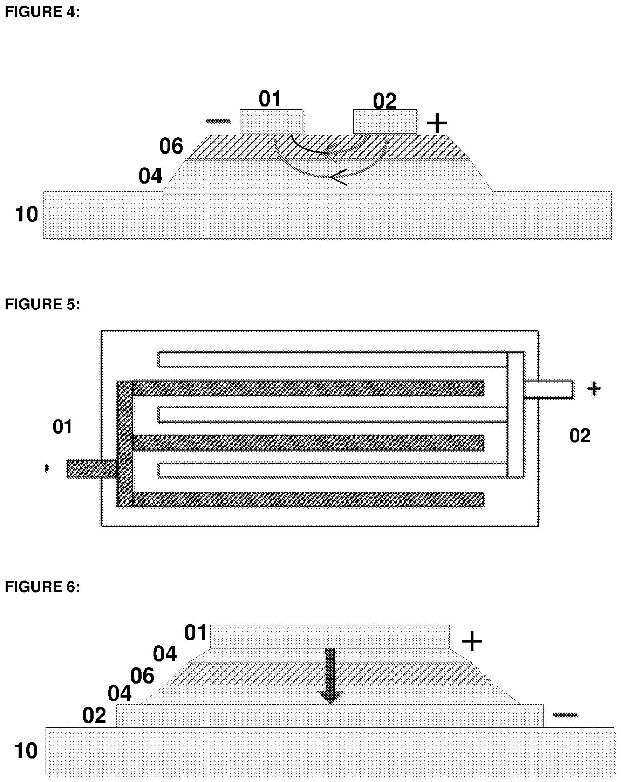

With reference to Figure 4, the electrical component of the invention also may be arranged so that first (01) and second (02) electrodes are disposed adjacent to one of the two opposing sides of the thin film ceramic member separated in the thickness direction. In that case, the first layer of thin film ceramic material (06) is disposed adjacent to the electrodes (01, 02). As can be seen from the schematic electric field lines depicted Figure 4, as in other embodiments, the first layer of thin film ceramic material (06) is disposed adjacent to the (low potential) electrode (01) to which the electric field is directed, thereby conferring the benefits of the invention in extending useable lifetime. Figure 5 shows a top view of an electrical component having a similar configuration as represented by Figure 4. Figure 5 shows an interdigitated pair of first (01) and second (02) electrodes provided on a single side of the thin film ceramic member (in this case the top side), wherein each of the electrodes comprises three electrode fingers.

Figure 6 shows a cross-sectional view of an electrical component having top (01) and bottom (02) electrodes interposed by a thin film ceramic member, which configuration is not in accordance with the present invention. The first layer of doped ceramic material (06) is positioned within the centre of the multilayer thin film ceramic member, with second layers (04) of thin film ceramic material interposing the first layer (06) and both of the top (01) and bottom (02) electrodes. Although Figure 6 shows operation in the field-down configuration, neither in field-up nor field-down configuration is the first layer of doped ceramic material (06) in contact with the low potential electrode. Consequently, the configuration of Figure 6 is incapable of achieving the benefits of the invention, as shown in more detail in the examples below.

As described above, the first layer of ceramic material is doped with one or more of the metal ions specified hereinbefore. The term "doped with" or "dopant" used herein refers to an ionic component (and typically a metallic ion selected from alkali, alkaline earth, transition and post-transition metals) which is incorporated into the ceramic material, for instance by including with the precursor components used for preparation of the ceramic material, in order to modify performance or engineering characteristics of the ceramic material, without having any material impact on the overall phase of the ceramic material.

The first layer of thin film ceramic material may comprise any suitable total concentration of the one or more transition and/or non-transition metal ions described hereinbefore. A suitable concentration range of dopant metal ion selected from these metal ions is from 0.1 to 10 at.%. As will be appreciated, the upper limit of concentration is dictated by the one or more dopant metal ions' solubility in the ceramic material. In preferred embodiments, the concentration of the one or more dopant metal ions defined above in the first layer of ceramic material ranges from 0.5 to 5 at.%, more preferably from 1 to 3 at.%, most preferably from 1.5 to 2.5 at.%.

As will be appreciated, where a third layer of ceramic material is present that is as defined for the first layer, the concentration ranges of the one or more dopant metal ions may be the same as recited above the first layer.

Although the second layer of ceramic material is not doped with the one or more transition metal ions capable of Jahn-Teller distortion of the perovskite ($ABX_3$) crystal structure of the ceramic material and/or the one or more non-transition metal ions which either have a lower oxidation state and/or the one or more transition metal ions which preferentially undergo reduction, compared to the B-site cation of the perovskite ($ABX_3$) crystal structure of the ceramic material, as in the case of the first layer of ceramic material, it is possible for the second layer of ceramic material to be doped with one or more alternative dopants in order to modify the properties of the second layer of ceramic material and/or the ceramic member as a whole, as desired. It will therefore also be appreciated that the first layer (and third layer if present) may also be additionally doped with one or more alternative dopants to those specified hereinbefore. For instance, alternative dopants to those specified hereinbefore may be used to modify grain size and domain mobility, or to improve resistivity (e.g. by compensating for excess charge carriers) and temperature dependence of some properties. Examples of such alternative dopants include ions of Mg, Nb and Ca.

In some embodiments, the second layer of ceramic material of the invention contains less than 10at.%, preferably less than 5 at%, more preferably less than 2 at.%, even more preferably less than 0.5 at.%, of one or more alternative dopant metal ions not selected from the one or more metal ions capable of Jahn-Teller distortion of the perovskite ($ABX_3$) crystal structure of the ceramic material and/or the one or more metal ions which either have a lower oxidation state or which preferentially undergo reduction compared to the B-site cation of the perovskite ($ABX_3$) crystal structure of the ceramic material, as described in connection with the first layer of ceramic material. In some embodiments, the second layer of ceramic material of the invention contains no dopant metal ion, whatsoever.

In some embodiments, the first layer of ceramic material of the invention contains no additional alternative dopant ions to the one or more transition metal ions capable of Jahn-Teller distortion of the perovskite ($ABX_3$) crystal structure of the ceramic material and/or the one or more non-transition metal ions which have a lower oxidation state and/or the one or more transition metal ions which preferentially undergo reduction, compared to the B-site cation of the perovskite ($ABX_3$) crystal structure of the ceramic material, as described hereinbefore.

In some embodiments, the first layer of ceramic material is doped with one or more ions from only one of Ag, Co, Cr, Cu, Fe, Mn, Mo, Ni, Re and V.

In some embodiments, the first layer of ceramic material is doped with one or more ions selected from ions of Ag, Cr, Cu, Mn, and Re, and combinations thereof.

In some embodiments, the first layer of ceramic material is doped with one or more ions selected from ions of Cr, Co, Cu, Fe, Mn, Mo, Ni, V and combinations thereof.

In preferred embodiments, the first layer of ceramic material comprises one or more ions of Cu, Cr and/or Mn as dopant(s).

In particularly preferred embodiments, the first layer of ceramic material comprises one or more ions of Mn as dopant(s), for example, $Mn^{2+}$, $Mn^{3+}$ and $Mn^{4+}$ ions, and more preferably in the absence of any other dopant ions of Ag, Co, Cr, Cu, Fe, Mo, Ni, Re, and V, and even more preferably in the absence of any other dopant ions whatsoever.

The beneficial effect brought about by the invention is attainable for a wide range of relative thicknesses of first and second layers, and third layer when present. However, in order to balance piezoelectric / electrostrictive performance of the ceramic member together with usable lifetime, it is preferred that the majority of the thickness of the ceramic member is contributed by the second layer of thin film ceramic material.

The thickness of the first layer of ceramic material may suitably be from 1 % to 30% of the total thickness of the thin film ceramic member. In preferred embodiments, the first layer of ceramic material is from 1 to 10% of the total thickness of the thin film ceramic member, more preferably from 2% to 8% of the total thickness of the thin film ceramic member; most preferably from 3% to 5% of the total thickness of the thin film ceramic member.

Thus, in another aspect, the present invention provides an electrical element for use in microelectromechanical systems wherein the first layer of ceramic material is from 1 to 10% of the total thickness of the thin film ceramic member, more preferably from 2% to 8% of the total thickness of the thin film ceramic member; most preferably from 3% to 5% of the total thickness of the thin film ceramic member.

In some embodiments, the thickness of the first layer of ceramic material ranges from 10 to 200 nm, preferably from 20 to 100 nm, more preferably from 40 to 80 nm.

The thickness of the second layer of ceramic material may suitably range from 70% to 99% of the total thickness of the thin film ceramic member. In preferred embodiments, the second layer of ceramic material ranges from 90% to 99% of the total thickness of the thin film ceramic member, more preferably from 92% to 98% of the total thickness of the thin film ceramic member; most preferably from 93% to 95% of the total thickness of the thin film ceramic member.

In some embodiments, the thickness of the second layer of ceramic material ranges from 75 to 500 nm, preferably from 100 to 300 nm, more preferably from 125 to 200 nm.

When present, the thickness of the third layer of ceramic material may suitably be from 1% to 30% of the total thickness of the thin film ceramic member. In preferred embodiments, the third layer of ceramic material is from 1 to 10% of the total thickness of the thin film ceramic member, more preferably from 2% to 8% of the total thickness of the thin film ceramic member; most preferably from 3% to 5% of the total thickness of the thin film ceramic member.

In some embodiments, the thickness of the third layer of ceramic material ranges from 10 to 200 nm, preferably from 20 to 100 nm, more preferably from 40 to 80 nm, when present in the ceramic member.

The first and second layers of ceramic material forming the thin film ceramic member, and the third layer of ceramic material when present, may each comprise a plurality of sub-layers, for instance, as a result of multiple rounds of a thin film deposition process. Thus, in other words each of the first and second layers of ceramic material, and third layer if present, may be a laminate of sub-layers. In some embodiments, the first layer of ceramic material is a laminate of multiple sub-layers of the doped ceramic material, preferably wherein the first layer is a laminate of from 2 to 10 sub-layers, more preferably from 3 to 5 sub-layers. In some embodiments, the second layer of ceramic material is a laminate of multiple sub-layers of the ceramic material, preferably wherein the second layer is a laminate of from 2 to 10 sub-layers, more preferably from 3 to 5 sub-layers. In some embodiments, the third layer of ceramic material, if present, is a laminate of multiple sub-layers of the ceramic material, preferably wherein the second layer is a laminate of from 2 to 10 sub-layers, more preferably from 3 to 5 sub-layers. In alternative embodiments, the first layer (and third layer, if present) comprises only a single layer of, preferably spin-coated, ceramic material and does not correspond to a laminate of sub-layers.

As will be appreciated, the composition of the ceramic material of each of the sub-layers of one of the first or second layers, or third layer if present, may be the same or different. For example, the composition of one sub-layer may be selected based on its position within the ceramic member in relation to the electrodes. For instance, where a sub-layer is intended to be used as a seed layer for texturing further sub-layers to be applied thereon, the composition of such a layer may be optimised for that function, whilst further sub-layers may have different composition-. Where the first or second layer is a laminate of multiple sub-layers, the composition of each sub-layer may substantially be the same or identical, or it may vary from sub-layer to sub-layer

In some embodiments, where the first or second layer is a laminate of multiple sub-layers, the concentration of the one or more metal dopant ions selected from ions of Ag, Co, Cr, Cu, Fe, Mn, Mo, Ni, Re, and V in each sub-layer is substantially the same (e.g. within $\pm$ 2% concentration difference between layers) or identical. In other embodiments, the concentration of the dopant ion may be modified in each of the sub-layers so as to provide a concentration gradient across the sub-layers (for example, increasing concentration to the uppermost or lowermost sub-layer which is disposed adjacent the electrode(s)). As will be appreciated, establishing such a concentration gradient may however rely on the use of particular annealing temperatures in the film forming process to mitigate dopant ion migration between sub-layers. The skilled person is able to select suitable processing conditions in order to tailor (or engineer) such dopant ion migration.

As described hereinbefore, the thin film ceramic material which is used in the preparation of the thin film ceramic member in accordance with the invention comprises a major proportion of a perovskite crystallographic phase and is a dielectric exhibiting piezoelectric / electrostrictive properties which make it suitable for use in microelectromechanical systems. In the perovskite structure, "$ABX_3$", 'A' and 'B' are cations of different sizes, and X is an anion that bonds to both cations. As will be appreciated by the skilled person, it is understood that multiple cations can occupy the A- or B-sites of the perovskite structure. The X anion of the perovskite is typically an oxygen ion, but may also be selected from anions of S, Se, F, Cl and I.

As will be appreciated by the skilled person, the ceramic material of the first and second layers of the ceramic member may be different or the same. Thus, in some embodiments, the ceramic material of the second layer of the ceramic member may differ from the first layer only in the absence of the one or more transition metal ions capable of Jahn-Teller distortion of the perovskite ($ABX_3$) crystal structure of the ceramic material and/or the one or more non-transition metal ions which either have a lower oxidation state and/or the one or more transition metal ions preferentially undergo reduction compared to the B-site cation of the perovskite ($ABX_3$) crystal structure of the ceramic material.

In some embodiments, the ceramic material of the electrical element of the invention comprises lead, titanium, zirconium, niobium and/or zinc ions. Examples of lead-based ceramic materials that may be used in accordance with the present invention include $Pb[Zr_xTi_{1-x}]O_3$ ($0 \leq x \leq 1$), $Pb[(Zn_{1/3}Nb_{2/3})_xTi_{1-x}]O_3$ $0<x<1$, and $Pb[(Mg_{1/3}Nb_{2/3})_xTi_{1-x}]O_3$ ($0<x<1$). In some embodiments, at least the ceramic material of the first layer of the ceramic member comprises titanium ions, preferably where the titanium ions occupy the B-site of perovskite crystal structure (for example, in the form of the $Ti^{4+}$ ion).

EP 3 791 433 B1

In some embodiments, the ceramic material of the electrical element is lead-free and preferably contains bismuth, sodium and/or potassium ions. Examples of such lead-free ceramic materials include $(Bi_{0.5}Na_{0.5})TiO_3$, $(Bi_{0.5}K_{0.5})TiO_3$, $Bi(Mg_{0.5}Ti_{0.5})O_3$ and $(K_{0.5}Na_{0.5})NbO_3$, $BiFeO_3$ and solid solutions comprising combinations thereof.

In some embodiments, a bismuth-based solid solution is used as the ceramic material of the electrical element which is either doped or not by one or more ions selected from ions of Ag, Cr, Cu, Fe, Mn, Mo, Ni, Re, Co and V so as to be the first or second layer of the thin film ceramic member, respectively.

The term "solid solution" used herein refers to a mixture of two or more crystalline solids that combine to form a new crystalline solid, or crystal lattice, that is composed of a combination of the elements of the constituent compounds. The solid solution exists over a partial or complete range of proportions or mole ratios of the constituent compounds, where at least one of the constituent compounds may notionally be considered to be the "solvent" phase (i.e. the constituent compound(s) which are corresponding to a major mole fraction of the solid solution).

In preferred embodiments, a bismuth-based solid solution is used as the ceramic material of the electrical element having the formula (I): $xA\text{-}yB\text{-}z_1C_1\text{-}z_2C_2$, wherein A corresponds to a first bismuth based perovskite component; B is a second bismuth based perovskite component; $C_1$ and $C_2$ are optional dopant perovskite components, and wherein: $x+y+z_1+z_2 = 1$; $x, y \neq 0$; and $(z_1 + z_2) \geq 0$. As will be appreciated by the skilled person, the dopant perovskite components $C_1$ and $C_2$ differ from the one or more dopant ions that are added to the first thin film ceramic layer discussed hereinbefore. The dopant ions used in accordance with the present invention may occupy A- or B-sites of the perovskite structure of the ceramic material, but do not form a distinct perovskite component as part of a multi-component solid solution.

Perovskite components A and B of formula (I) correspond to a major molar proportion of the solid solution ceramic material (i.e. greater than 50 mol.%). In other words, $(x + y) > 0.5$. In preferred embodiments, $(x + y) > 0.6$; more preferably $(x + y) > 0.7$, still more preferably $(x + y) > 0.75$; and even more preferably $(x + y) > 0.8$.

The optional and different dopant perovskite components $C_1$ and $C_2$ are collectively present as a minor molar fraction (i.e. less than 50 mol.%) of the solid solution ceramic material of formula (I) and are generally incorporated to modify the microstructure of the solid solution ceramic material, for instance to optimise ferroelectric and piezoelectric properties. In other words, $(C_1 + C_2) < 0.5$. In preferred embodiments, $(C_1 + C_2) < 0.2$; more preferably $(C_1 + C_2) < 0.15$, still more preferably $(C_1 + C_2) < 0.10$.

In some embodiments, A of formula (I) is $(Bi_{0.5}Na_{0.5})TiO_3$ and B of formula (I) is $(Bi_{0.5}K_{0.5})TiO_3$. In related embodiments, $(C_1 + C_2) = 0$, such that the solid solution ceramic material of formula (I) is $(Bi_{0.5}Na_{0.5})TiO_3\text{-}(Bi_{0.5}K_{0.5})TiO_3$ ("BNT-BKT").

In some embodiments, $C_1$ and/or $C_2$ of formula (I) are independently selected from $SrHfO_3$, $SrZrO_3$, $Bi(Mg_{0.5}Ti_{0.5})O_3$, $Bi(Zn_{0.5}Ti_{0.5})O_3$, $Bi(Ni_{0.5}Ti_{0.5})O_3$, $KNbO_3$, $NaNbO_3$, $(K_{0.5}Na_{0.5})NbO_3$, $(Bi_{0.5}Li_{0.5})TiO_3$, $(Bi_{0.5}Na_{0.5})HfO_3$ and $(Bi_{0.5}K_{0.5})HfO_3$. In related embodiments, the solid solution ceramic material of formula (I) is $(Bi_{0.5}Na_{0.5})TiO_3\text{-}(Bi_{0.5}K_{0.5})TiO_3\text{-}Bi(Mg_{0.5}Ti_{0.5})O_3$ ("BNT-BKT-BMT").

In other embodiments, the bismuth-based solid solution ceramic material has a composition according to the formula (Ia):

$$(Ia): \quad x(Bi_{0.5}Na_{0.5})TiO_3\text{-}y(Bi_{0.5}K_{0.5})TiO_3\text{-}z_1SrHfO_3\text{-}z_2SrZrO_3$$

$$x+y+z_1+z_2 = 1; \; x, \; y \neq 0; \; (z_1 + z_2) > 0.$$

In preferred embodiments, $0.25 \leq x \leq 0.65$, more preferably $0.35 \leq x \leq 0.55$, most preferably $0.40 \leq x \leq 0.50$ in formula (Ia).

In preferred embodiments, $0.25 \leq y \leq 0.75$, more preferably $0.35 \leq y \leq 0.55$, most preferably $0.40 \leq y \leq 0.50$ in formula (Ia).

In preferred embodiments, $0.01 \leq (z_1+z_2) \leq 0.15$, more preferably $0.02 \leq (z_1+z_2) \leq 0.10$, most preferably $0.04 \leq (z_1+z_2) \leq 0.08$ in formula (Ia).

In preferred embodiments, $0.40 \leq x \leq 0.50$; $0.40 \leq y \leq 0.50$; and $0.02 \leq (z_1+z_2) \leq 0.10$ in formula (Ia).

In other embodiments, one of z1 and z2 = 0, such that only one of $SrHfO_3$ and $SrZrO_3$ is present in the solid solution.

The first and second electrodes employed in the electrical element of the present invention are not particularly limited. Suitably, the first and/or second electrodes are layers of platinum, iridium, iridium oxide, ruthenium, $LaNiO_3$, $SrRuO_3$, or combinations thereof. In some embodiments, both first and second electrodes comprise platinum. Platinum is particularly preferred as a result of its high conductivity and high chemical stability, as well as its resistance to oxidation in oxygen environments at high temperatures.

In some embodiments where first and second electrodes are top and bottom electrodes interposed by the thin film ceramic member, the top electrode comprises iridium oxide, preferably in combination with iridium metal. Iridium oxide can neutralise oxygen vacancies in the underlying thin film ceramic layer and therefore can enhance the lifetime extending properties of the invention.

**Preparation of the ceramic member**

Preparation of products for thin film microelectromechanical systems (MEMS) applications typically involves chemical solution deposition using chemical precursors, or sputtering (e.g. RF magnetron sputtering) using solid state sintered or hot-pressed ceramic targets.

The ceramic member of the electrical element of the present invention may be prepared by any suitable solid-state synthesis method of which the skilled person is familiar using the appropriate amounts of precursors, typically precursor oxides or carbonates. In general, conventional solid state synthesis methods for making ceramic materials involve milling of the powder precursors, followed by shaping and calcining to produce the desired ceramic product. Milling can be either wet or dry type milling. High energy vibratory milling may be used, for instance, to mix starting powders, as well as for post-calcination grinding. Where wet milling is employed, the powders are mixed with a suitable liquid (e.g., ethanol or water, or combinations thereof) and wet milled with a suitable high density milling media (e.g., yttria stabilized zirconia (YSZ) beads). The milled powders are calcined, then mixed with a binder, formed into the desired shape (e.g., pellets) and sintered to produce a ceramic product with high sintered density.

The ceramic member may also be fabricated by any suitable deposition method. For example, atomic layer deposition (ALD), chemical vapor deposition (CVD) (including plasma-enhanced chemical vapor deposition (PECVD) and metalorganic chemical vapor deposition (MOCVD)), and chemical solution deposition (CSD), including sol-gel deposition, may be employed using appropriate precursors. Preferably sol-gel deposition is used for fabricating the thin film ceramic member.

Examples of suitable precursors include lead acetate trihydrate, lead oxide, titanium (IV) isopropoxide, titanium butoxide, bismuth acetate, bismuth nitrate, bismuth 2-ethylhexanoate, barium acetate, barium nitrate, barium 2-ethylhexanoate, sodium acetate trihydrate, sodium nitrate, potassium acetate, potassium nitrate, magnesium acetate tetrahydrate, magnesium nitrate, zinc acetate and zinc nitrate. Suitable solvents that may be employed in these methods where appropriate include alcohols (for example, methanol, ethanol and 1-butanol) and organic acids (for example, acetic acid and propionic acid). Suitable stabilisers that may be employed in these methods where appropriate include acetylacetone and diethanolamine.

To compensate for the high volatility of certain cations, precursor solutions may be prepared with amounts of excess cations added thereto. Use of excess cations is common in CSD-prepared PZT thin films (for example, up to 20 mol%-40 mol% excess $Pb^{2+}$ can be added, depending on solution chemistry). Use of excess cations in the preparation of lead-based thin films is also known to improve lifetime and therefore may also be used in combination with the present invention to enhance lifetime yet further. It is also well-known that bismuth, sodium, and potassium ions are all volatile, particularly at process temperatures typical of perovskite crystallization. The vapour pressures of $K_2O$ and $Na_2O$ are especially high, being comparable with that of PbO. Therefore, in a similar manner, bismuth cation precursor solutions used in connection with lead-free embodiments of the present invention, as well as precursor solutions of other cations, particularly those comprising sodium and potassium, may comprise excess cations and the skilled person is able to determine an appropriate level of excess cations to be used.

Use of excess cations in the precursor solutions can therefore be beneficial in ensuring that the desired stoichiometry is achieved which can be advantageous for the durability/resistance to conduction of the resulting films. If there is a stoichiometric imbalance, point defects, which contribute to the space charge limited current, can occur. As will be appreciated, improving resistance to leakage/breakdown may then necessitate applying higher fields to achieve the desired degree of displacement.

In the manufacture of an electrical component including a substrate as described hereinbefore, the precursor solution may be deposited by any suitable means of which the skilled person is aware. Such means include dip- or spin-coating, preferably spin coating, which are commonly utilised in chemical solution deposition processes.

Dip-coating involves immersing a substrate in a container of precursor solution and depositing the precursor solution on to the substrate as the substrate is withdrawn, typically at constant speed. The speed at which the substrate is withdrawn from the container of precursor solution effectively determines the thickness of the coating, faster withdrawal giving rise to a thicker coating. In contrast, spin-coating typically involves the use of a spin-coat apparatus in which a substrate may be secured and spun in the proximity of a dispenser from which the precursor solution may be dispensed on to the substrate whilst being spun or shortly before spinning commences.

Typically, deposition and rotation where spin-coating is employed, or immersion and withdrawal where dip-coating is used, is conducted so as to provide a coating layer having a thickness of from 10 nm to 500 nm, preferably from 15 to 200 nm, more preferably from 20 to 100 nm. As discussed in more detail below, multiple layers may be deposited so as to form the multilayer ceramic member in accordance with the present invention, where first and second layers may be formed from multiple sub-layers providing a laminate structure. It will be appreciated that the thickness of the layers/sub-layers depends on the deposition process, such as spin speed for spin-coating or withdrawal speed for dip-coating, as well as the viscosity, volatility of solvent and concentration of the precursor solution.

Where first and second layers of the thin film ceramic material comprise multiple sub-layers, each additional sub-layer is formed directly on the previously deposited sub-layer with no intervening layers there between, provided that the previously deposited layer has undergone at least drying and pyrolysis, and in some cases also crystallization, as discussed in more detail below. Alternatively, the first and second thin film layers described herein may each be formed from only a single deposited layer having a sufficient thickness.

Deposition of the precursor solution is typically conducted at from room temperature (for example, 20 °C) up to a temperature of 100 °C. Higher deposition temperatures may lead to near simultaneous evaporation of the solvent of the precursor solution upon deposition.

As the skilled person is aware, it is possible to heat the substrate upon which the precursor solution is to be deposited in order to facilitate drying and pyrolysis. For example, spray pyrolysis may be used which typically relies on the use of a heated substrate.

Prior to deposition on the bare substrate, it is usual for the substrate to be cleaned to remove residue and dirt. Removing residual organics on the substrate surface typically involves washing with low molecular weight volatile compounds, such us methanol, ethanol, isopropanol and/or acetone followed by evaporation of the volatile compounds by heating the substrate. Other techniques including ultrasonic bath and plasma etching may also be relied upon as part of the substrate cleaning process.

The nature of the substrate which may be employed in the electrical component in an aspect of the present invention is not particularly limited. Examples include silicon wafers which may be metalised so as to also provide, for instance, the bottom electrode in embodiments of the invention. For example, M/Ti/SiO$_2$/Si metalised wafers are preferred, where M is a metal selected from platinum, iridium or ruthenium, preferably platinum. Stainless steel, glass, MgO and sapphire may also be used as the substrate, or a layer thereof, for the electrical component. The substrate may include any number of constituent layers provided it retains suitability for microelectromechanical systems applications.

In some embodiments, the substrate is a diaphragm which is: i) a metal or metal oxide layer that functions as a lower electrode; or ii) a non-metal layer coated with a metal layer that provides an electrically conductive lower electrode. In preferred embodiments, the diaphragm is a layer of platinum, iridium, iridium oxide or ruthenium, more preferably platinum.

Following deposition of the precursor solution, forming of the thin film typically involves drying to remove the solvent of the precursor solution and pyrolysing to cause reaction of the precursor compounds so as to form an amorphous layer comprising the ceramic material. The crystallization step subsequently transforms the amorphous layer into a thin film comprising a major proportion of the perovskite phase, preferably at least 90 vol. % of the perovskite phase, more preferably at least 95 vol. % of the perovskite phase, even more preferably at least 98 vol.% of the perovskite phase, and most preferably 100 vol.% of the perovskite phase. As will be appreciated, drying and pyrolysing may be carried out in a single step, or as distinct sub-steps. Thereafter, crystallization of the precursor layer is effected by heating to a crystallisation temperature / annealing temperature (i.e. to a temperature where changes in the microstructure of the initially amorphous coating layer are possible).

The conditions for drying and pyrolysing are not particularly limited so far as there is no potential impact on the morphology and/or porosity of the resulting amorphous coating layer or any decomposition of the materials at high temperature. Generally, the minimum temperature for drying is dictated by the lowest-boiling point solvent that is present in the precursor solution. Similarly, the minimum temperature for the pyrolysis step is dependent upon the precursor having the lowest pyrolysis temperature. Suitable temperatures over which drying may be conducted are from 60 °C to 250 °C, preferably from 100 °C to 200 °C, and suitably over a time period of from 1 to 5 minutes, preferably from 2 to 3 minutes. Suitable temperatures over which pyrolysis may be conducted are from 150 °C and 500 °C, preferably from 250 °C to 450 °C, more preferably from 300 °C to 375 °C, and suitably over a time period of from 1 to 10 minutes, preferably 2 minutes to 8 minutes, more preferably from 3 to 5 minutes.

A typical crystallisation temperature that may be used is from 600 °C to 800 °C. "Crystallisation temperature" or "annealing temperature" used herein is intended to mean the temperature to which the amorphous deposited layer or layers is heated and at which temperature a transition from an amorphous to a crystalline phase is possible (i.e. an annealing temperature for the material).

Rapid Thermal Processing (RTP) is a versatile heating method which can be used for semiconductor processing as well as for controlled heating of objects which are in the form of sheets or discs, including thin and thick films. Heating is generally conducted in a chamber having one or more walls including a transparent portion, typically comprising quartz, so as to allow transmittance of radiation from powerful heating lamps. Radiation from a halogen lamp, an infrared lamp, or an ultraviolet lamp may suitably provide the source of heat in the RTP. Preferably, tungsten-halogen lamps are used. RTP may be used in preparation of the thin film ceramic member of the electrical element of the present invention.

As the ceramic material is fabricated as a thin film, it will be appreciated that tensile stresses associated with the thin film can affect field-induced strains and the magnitude of the effective piezoelectric coefficient $d_{33}{}^*$. The skilled

person is able to determine the extent of residual tensile stresses associated with a fabricated thin film and take steps to control such stresses (for example, by utilising thermal anneals to relieve stress, by designing the device architecture to achieve a desired stress state, and by adjusting film thickness) in order to gain the maximum benefit of the field-induced strains associated with the ceramic materials of the present invention.

As will be appreciated, this approach can also, for instance, be utilised when the ceramic material is fabricated as a thin film forming part of an actuator component of a droplet deposition apparatus, described in further detail below. The skilled person is able to accommodate for, or mitigate, intrinsic stresses resulting from the configuration of the actuator component so as to ensure that the reversible phase transition associated with the ceramic material of the invention is possible in response to an electric field. Thus, as applied to the droplet deposition apparatus, the skilled person is able to ensure that the gain or loss of electric field induced strain caused by the application of an ejection waveform to an actuator element comprising the ceramic member is sufficient to cause ejection of a droplet. In one example, this might be accomplished by appropriate design of the ejection waveform. This may, for instance, include identifying a suitable amplitude for the ejection waveform (e.g. suitable peak-to-peak amplitude) and/or identifying suitable maximum and minimum voltage values (with the characteristic phase transition occurring upon change between maximum and minimum voltage values). The thus-designed ejection waveform may accommodate for, or mitigate, the effect that intrinsic stresses have on the conditions necessary to elicit the reversible phase transition.

Effective piezoelectric coefficient ($d_{33}^*$), electromechanical strain response and polarisation hysteresis measurements may be carried out using any suitable measurement device familiar to the skilled person, including, for example, an AixACCT Piezoelectric Characterization System fitted with an interferometer.

The electrical element in accordance with the present invention may be employed as actuating elements in a variety of actuator components. For instance, such an actuator component may find use in a droplet deposition apparatus. Droplet deposition apparatuses have widespread usage in both traditional printing applications, such as inkjet printing, as well as in 3D printing and other materials deposition or rapid prototyping techniques.

Thus, in another aspect, the present invention provides an actuator component for use in a droplet deposition apparatus comprising an electrical element as defined above. In a related aspect, the present invention also provides a droplet deposition apparatus comprising the actuator component.

An actuator component suitable for use in a droplet deposition apparatus may, for instance, comprise a plurality of fluid chambers, which may be arranged in one or more rows, each chamber being provided with a respective actuator element and a nozzle. The actuating element is actuable to cause the ejection of fluid from a chamber of the plurality through a corresponding one of the nozzles. The actuating element is provided with the first and second electrodes as described hereinbefore which are configured to apply an electric field to the actuating element, which is thereby deformed, thus causing droplet ejection. Additional layers may also be present, including insulating, semiconducting, conducting, and/or passivation layers, provided they do not prevent attainment of the benefits of the invention (i.e. provided they do not interpose the first layer of ceramic material and the electrode(s)). Such layers may be provided using any suitable fabrication technique such as, for example, a deposition/machining technique, e.g. sputtering, CVD, PECVD, MOCVD, ALD, laser ablation etc. Furthermore, any suitable patterning technique may be used as required, such as photolithographic techniques (e.g. providing a mask during sputtering and/or etching).

The actuating element may, for example, function by deforming a wall bounding one of the fluid chambers of the actuator component. Such deformation may in turn increase the pressure of the fluid within the chamber and thereby cause the ejection of droplets of fluid from the nozzle. Such a wall may be in the form of a membrane layer which may comprise any suitable material, such as, for example, a metal, an alloy, a dielectric material and/or a semiconductor material. Examples of suitable materials include silicon nitride ($Si_3N_4$), silicon oxide ($SiO_2$), aluminium oxide ($Al_2O_3$), titanium oxide ($TiO_2$), silicon (Si) or silicon carbide (SiC). The actuating element may include the ceramic material described herein in the form of a thin film. Such thin films may be fabricated, including in multiple layers, using different techniques well known to the skilled person, including sputtering, sol-gel, chemical solution deposition (CSD), aerosol deposition and pulsed laser deposition techniques.

The droplet deposition apparatus typically comprises a droplet deposition head comprising the actuator component and one or more manifold components that are attached to the actuator component. Such droplet deposition heads may, in addition, or instead, include drive circuitry that is electrically connected to the actuating elements, for example by means of electrical traces provided by the actuator component. Such drive circuitry may supply drive voltage signals to the actuating elements that cause the ejection of droplets from a selected group of fluid chambers, with the selected group changing with changes in input data received by the head.

To meet the material needs of diverse applications, a wide variety of alternative fluids may be deposited by droplet deposition heads as described herein. For instance, a droplet deposition head may eject droplets of ink that may travel to a sheet of paper or card, or to other receiving media, such as textile or foil or shaped articles (e.g. cans, bottles etc.), to form an image, as is the case in inkjet printing applications, where the droplet deposition head may be an inkjet printhead or, more particularly, a drop-on-demand inkjet printhead.

Alternatively, droplets of fluid may be used to build structures, for example electrically active fluids may be deposited onto receiving media such as a circuit board so as to enable prototyping of electrical devices. In another example, polymer containing fluids or molten polymer may be deposited in successive layers so as to produce a prototype model of an object (as in 3D printing). In still other applications, droplet deposition heads might be adapted to deposit droplets of solution containing biological or chemical material onto a receiving medium such as a microarray.

Droplet deposition heads suitable for such alternative fluids may be generally similar in construction to printheads, with some adaptations made to handle the specific fluid in question. Droplet deposition heads which may be employed include drop-on-demand droplet deposition heads. In such heads, the pattern of droplets ejected varies in dependence upon the input data provided to the head.

The present invention will now be described by reference to the following Examples, which are intended to be illustrative of the invention and in no way limiting.

**Examples**

General Preparation Method

Electrical components comprising a multilayer thin film ceramic member comprising niobium doped lead zirconate titanate (PNZT) and manganese doped lead zirconate titanate (PMZT), interposing bottom and top electrodes were prepared for testing. All thin films were deposited by sol-gel deposition using appropriate precursor solutions for PNZT (used to form the bulk film corresponding to the second layer of ceramic material in accordance with the invention) and for PMZT (corresponding to the first layer of doped ceramic material in accordance with the invention). A suitable lead excess was used in the precursor solutions for preparation of the second layer of PNZT. Similarly, a suitable lead excess was used In PMZT film layers, which was varied with the concentration of the dopant to maintain stoichiometry as far as possible between the different samples. For samples with a PMZT layer disposed adjacent the top electrode, the lower lying PNZT film layer was formed on platinised silicon as the bottom electrode with a 15 wt.% PNZT precursor solution. The PMZT layer was subsequently deposited on the PNZT bulk film layer in the different samples with different PMZT precursor solutions having different concentrations of Mn dopant ion and at varying film thicknesses. Where the PMZT layer is instead disposed adjacent the bottom electrode (a seed layer for formation of the thin-film ceramic member), the same platinised silicon bottom electrode was used and the PNZT film was formed on top of the PMZT seed layer. A platinum top electrode was used in all instances.

All solutions were spin coated onto a substrate at 3500 rpm for 45 seconds with a dynamic dispense at 500 rpm. After spin-coating, films were dried at 100 °C for 1 minute and pyrolyzed at 300 °C for 4 minutes. Finally, samples were crystallised in a rapid thermal annealer (RTA) at 700 °C for 1 minute under 2 SLPM of $O_2$ flow, with a heating rate of 10 °C/s.

Changes in Mn dopant oxidation state were observed during the preparation process and following crystallization. Nevertheless, the largest populations of the different Mn ions present were attributed to the $3^+/4^+$ oxidation states..

Highly accelerated lifetime tests (HALTs)

HALTs were performed using a Keithley picoammeter as a direct current (DC) source and leakage current measurement tool. 20 capacitor samples were placed in a 24-pin dual in-line package (DIP). The top electrodes were wire bonded to the contact pads of the package with Au wire. Labview based software monitored the leakage current across the samples versus time. HALT measurements were conducted at a temperature of 200°C with a DC electrical field of 300 kV/cm and the duration of median lifetime for a tested sample ascertained

**Example 1**

A number of thin film ceramics were prepared in accordance with the above general preparation method. For each sample, the bulk film of PNZT (precursor solution composition: 114/2/52/48) was deposited adjacent the bottom electrode at a film thickness of 1.5 $\mu$m and a top layer of PMZT (precursor solution composition: 114/x/52/48, where x = 1, 2 or 3) was deposited on the PNZT layer, so as to interpose the bulk film of PNZT and the top electrode. The top layer of PMZT was provided with a film thickness of approximately 60 to 70 nm and having dopant Mn ion concentration varying from 1 at.% to 3 at.%. For comparative purposes, a sample comprising only a PNZT as the thin film ceramic member also was tested.

The samples were operated in either field-up configuration (meaning that the top electrode is the low potential electrode) or field-down configuration (meaning that the bottom electrode is the low potential electrode). HALTs analysis was performed for 20 samples prepared for each thin film ceramic composition/configuration tested and the duration of median lifetime ($t_{50}$), based on the time taken for 50 % of the samples to fail, was assessed. Failure in this context is defined based on the leakage current value of the thin film ceramic member exceeding a threshold value of 100 times the minimum leakage current density detected for the thin film ceramic member of the electrical element. The results of the HALTs analysis are provided below in Table 1:

**Table 1**

| Thin film Ceramic Member | $t_{50}$ (hour) | |
|---|---|---|
| | Field UP | Field DOWN |
| PNZT (1.5 $\mu$m) | 14.4 | 27.2 |
| PNZT + 1% PMZT top layer | 34.7 | 48.7 |
| PNZT + 2% PMZT top layer | 65.0 | 33.5 |
| PNZT + 3% PMZT top layer | 93.9 | 10.7 |

The results of Table 1 demonstrate the improvement in median lifetime ($t_{50}$) associated with providing a first layer in accordance with the present invention (PMZT layer) in between the low potential electrode and the second layer (bulk PNZT layer).

As expected, pure PNZT bulk film, having no top layer of PMZT, operated in field down configuration gave a longer median lifetime ($t_{50}$) (27.2 versus 14.4 hours) in comparison to the pure PNZT operated in field-up configuration. As discussed hereinbefore, operation in field-up configuration has been known historically to provide shorter median lifetimes than operation in field-down configuration. However, as can be seen from the results in Table 1, inclusion of the PMZT top layer adjacent the top electrode (low potential electrode when operated in field-up configuration) substantially increases median lifetime ($t_{50}$) in the field-up configuration and well beyond the increase associated merely with operating instead in the field-down configuration with the pure PNZT sample. Notably, the median lifetime ($t_{50}$) provided by the sample with 3 at.% PMZT top layer operated in field-up configuration is over 3 times the duration of the pure PNZT sample operated in field-down configuration.

**Example 2**

The experiments of Example 1 were substantially repeated except that the PMZT containing samples each had a Mn ion dopant concentration of 2 at.%, and the thickness of the PMZT top layer was varied between approximately 50 nm and 150 nm. HALTs analysis of the samples was completed to assess the effect of the variation of the thickness of the PMZT top layer on median lifetime ($t_{50}$) and the results are provided below in Table 2, together with the results for the pure PNZT sample for comparison.

**Table 2**

| Thin film Ceramic Member | $t_{50}$ (hour) | |
|---|---|---|
| | Field UP | Field DOWN |
| PNZT (1.5 $\mu$m) | 14.4 | 29.6 |
| PNZT + PMZT top layer (47nm) | 102.0 | 20.0 |
| PNZT + PMZT top layer (96nm) | 108.2 | 26.2 |
| PNZT + PMZT top layer (147nm) | 73.5 | 27.8 |

The results of Table 2 also demonstrate the improvement in median lifetime ($t_{50}$) associated with providing a first layer (PMZT layer) in accordance with the present invention in between the low potential electrode and the second layer (bulk PNZT layer). In the field-up configuration, the top electrode is the low potential electrode which is adjacent to the PMZT top layer. The presence of the PMZT top layer with operation in the field-up configuration substantially extends median lifetime across the different top layer thicknesses, as shown. In contrast, when the a PMZT top layer is provided and operation is in the field-down configuration, no benefit is observed in terms of improvement of median lifetime ($t_{50}$). This is because the PMZT top layer is not disposed adjacent the low potential electrode, since the bottom electrode is the low potential electrode in the field-down configuration. Consequently, it is the PNZT bulk film which is instead disposed adjacent the low potential electrode.

These results confirm that, where the thin film ceramic member interposes the electrodes, the location of the first layer of doped ceramic material must be adjacent to the low potential electrode (i.e. the electrode to which the electric field is directed) to give rise to the benefits of the invention in extending median lifetime ($t_{50}$).

**Example 3**

A number of thin film ceramics were prepared in accordance with the above general preparation method. For each sample, the PMZT thin film was deposited adjacent the bottom electrode. As the PMZT layer therefore also functions as a seed layer for texturing the bulk film deposited thereon, the cationic ratio of the PMZT was modified from the composition used in the previous examples so as to favour performance as a seed layer (precursor solution compositions: 119/1/44/56 or 120/2/44/56). The seed layer of PMZT was provided with a film thickness of approximately 60 to 70 nm and having dopant Mn ion concentration of 1 at.% or 2 at.%. PNZT, having a thickness of 1.5$\mu$m, was deposited on the PMZT seed layer, so as to interpose the PMZT seed layer and the top electrode.

The samples were operated in either field-up configuration (meaning that the top electrode is the low potential electrode) or field-down configuration (meaning that the bottom electrode is the low potential electrode). HALTs analysis was performed for 20 samples prepared for each thin film ceramic composition/configuration tested and the duration of median lifetime ($t_{50}$), based on the time taken for 50 % of the samples to fail, was assessed. Failure in this context is defined based on the leakage current value of the thin film ceramic member exceeding a threshold value of 100 times the minimum leakage current density detected for the thin film ceramic member of the electrical element. The results of the HALTs analysis are provided below in Table 3 together with the results for the pure PNZT sample for comparison.

Table 3

| Thin film Ceramic Member | $t_{50}$ (hour) | |
|---|---|---|
| | Field UP | Field DOWN |
| PNZT (1.5 $\mu$m) | 14.4 | 27.2 |
| 1% PMZT seed + PNZT | 16.8 | 68.1 |
| 2% PMZT seed + PNZT | 18.2 | 94.6 |

The results of Table 3 demonstrate the improvement in median lifetime ($t_{50}$) associated with providing a first layer in accordance with the present invention in between the low potential electrode and the second layer (bulk PNZT layer). In the field-up configuration, the top electrode is the low potential electrode which is adjacent to the PNZT bulk layer in this example. The PMZT seed layer is instead disposed adjacent the bottom (high potential) electrode. Consequently, there is little improvement in median lifetime ($t_{50}$), as shown. In contrast, the presence of the PMZT seed layer with operation in the field-down configuration substantially extends median lifetime ($t_{50}$), as shown for the 2% Mn doped PZT sample ($t_{50}$ of 94.6 hours versus 27.2 hours for the pure PNZT sample). This improvement is provided as operation in the field-down configuration means that the PMZT seed layer is disposed adjacent the low potential electrode.

**Example 4**

To confirm the dependence of lifetime on the location of the PMZT layer, a sample which has a PMZT layer at the centre of the thin film stack, in the thickness direction, was also prepared and tested. A layer of PNZT (precursor solution composition: 114/2/52/48) of approximately 750 nm thickness was deposited on the bottom electrode, followed by a 2 at% Mn doped PZT (precursor solution composition: 114/52/48) layer 70 nm thick. A further layer of the PNZT of approximately 750 nm thickness was subsequently deposited on top of the PMZT layer, such that PNZT was adjacent both the bottom and top electrodes.

HALTs analysis was performed in the same manner as in the previous examples and the results are provided below in Table 4, together with the results obtained for samples with the thin film ceramic member having a PMZT top layer (Examples 1 and 2) and PMZT seed layer (Example 3) with the same dopant concentration and thickness, for comparison.

Table 4

| Thin film Ceramic Member | $t_{50}$ (hour) | |
|---|---|---|
| | Field UP | Field DOWN |
| PNZT (1.5$\mu$ nm) | 14.4 | 27.2 |
| PNZT + 2% PMZT top | 65.0 | 33.5 |

(continued)

| Thin film Ceramic Member | $t_{50}$ (hour) | |
|---|---|---|
| | Field UP | Field DOWN |
| 2% PMZT middle + PNZT | 13.1 | 24. 6 |
| 2% PMZT seed + PNZT | 18.2 | 94.6 |

The results above show that there is no improvement in median lifetime ($t_{50}$) where the first layer of doped ceramic material (i.e. the PMZT layer) is not disposed adjacent the low potential electrode. As in neither the field-up nor field-down configurations is the PMZT layer disposed adjacent the low potential electrode, the low potential electrode and PMZT layer being interposed by a layer of PNZT, no improvement in median lifetime ($t_{50}$) is observed in either configuration over the pure PNZT bulk film sample. This is in complete contrast to where a PMZT layer is provided as a top layer or a seed layer and operated in the field-up or field-down configuration, respectively, which results in a substantial improvement in median lifetime ($t_{50}$) over the pure PNZT bulk film sample, as shown in the comparative results of Table 4.

**Claims**

1. An electrical element for use in microelectromechanical systems comprising:

   i) a thin film ceramic member formed of a plurality of layers of ceramic material (04, 06, 08) having a proportion above 50 vol.% of a perovskite phase, said thin film ceramic member having a first side and an opposing second side spaced apart in a thickness direction;
   ii) first (01) and second (02) electrodes disposed adjacent to the thin film ceramic member - - - wherein, relative to each other, one of the first or second (01, 02) electrodes is a higher potential electrode and the other one of the first and second electrodes (01, 02) is a lower potential electrode, such that a potential difference is established between the first and second electrodes and through the thin film ceramic member during operation;

   wherein the thin film ceramic member comprises:

   a first layer of ceramic material (06) doped with:

   I) one or more transition metal ions capable of Jahn-Teller distortion of the perovskite crystal structure of the ceramic material and/or
   II) one or more non-transition metal ions which have a lower oxidation state and/or one or more transition metal ions which preferentially undergo reduction, compared to the B-site cation of the perovskite crystal structure of the ceramic material; and

   a second layer of ceramic material (04) not doped with any of the one or more metal ions as defined for the first layer of ceramic material (06);
   **characterised in that** said first layer of ceramic material (06) is located, over the thickness of the thin film ceramic member, so as to be:

   a) adjacent and in contact with both of the first (01) and second (02) electrodes such that there are no additional layers of material located between the first layer of ceramic material (06) and the first (01) and second (02) electrodes, wherein first (01) and second (02) electrodes are both disposed adjacent to one of the first or second sides of the thin film ceramic member; or
   b) adjacent and in contact with the one of the first (01) or second (02) electrodes which is the lower potential electrode such that there are no additional layers of material located between the first layer of ceramic material (06) and the one of the first (01) or second (02) electrodes which is the lower potential electrode, wherein first (01) and second (02) electrodes are interposed by the thin film ceramic member.

2. The electrical element according to Claim 1, wherein the thickness of said first layer of ceramic material (06) is from 1% to 10% of the total thickness of the thin film ceramic member, preferably from 2% to 8% of the total thickness of the thin film ceramic member; more preferably from 3% to 5% of the total thickness of the thin film ceramic member.

3. The electrical element according to Claim 1 or Claim 2, wherein the total concentration of the one or more metal ions according to I) and II) in the first layer of ceramic material (06) is from 0.1 to 10 at.%, preferably from 0.5 to 5 at.%, more preferably from 1 to 3 at.%, most preferably from 1.5 to 2.5 at.%.

4. The electrical element according to any one of the preceding claims, wherein the first layer of ceramic material (06) is doped with one or more ions selected from: i) ions of Ag, Co Cu, Mn, Re, and combinations thereof; or ii) ions of Co, Cr, Cu, Fe, Mn, Mo, Ni, V and combinations thereof.

5. The electrical element according to any one of the preceding claims, wherein the first layer of ceramic material (06) comprises one or more Mn ions as a dopant.

6. The electrical element according to any one of the preceding claims, wherein the ceramic material comprises lead, titanium, zirconium, niobium and/or zinc ions, preferably wherein the ceramic material is selected from $Pb[Zr_xTi_{1ix}]O_3$ ($0 \leq x \leq 1$) and/or $Pb[(Mg_{1/3}Nb_{2/3})_xTi_{1-x}]O_3$ ($0 < x < 0.9$).

7. The electrical element according to any one of Claims 1 to 5, wherein the ceramic material is lead-free and contains bismuth, sodium and/or potassium ions, preferably wherein the ceramic material is selected from one or more of $(Bi_{0.5}Na_{0.5})TiO_3$, $(Bi_{0.5}K_{0.5})TiO_3$, $Bi(Mg_{0.5}Ti_{0.5})O_3$, $(K_{0.5}Na_{0.5})NbO_3$, $BiFeO_3$ and solid solutions comprising combinations thereof.

8. The electrical element according to any one of the preceding claims, wherein the ceramic material of at least the first layer of ceramic material (06), preferably of all layers of the ceramic material, comprises one or more titanium ions occupying the B-site of the perovskite crystal structure.

9. The electrical element according any one of Claims 1 to 5, 7 and 8, wherein the ceramic material is a solid solution of formula (I) below:

$$(I): \qquad xA\text{-}yB\text{-}z_1C_1\text{-}z_2C_2$$

wherein A is a first bismuth based perovskite component; B is a second bismuth based perovskite component; $C_1$ and $C_2$ are dopant perovskite components; and wherein: $x+y+z_1+z_2 = 1$; $x, y \neq 0$; $(z_1 + z_2) \geq 0$.

10. The electrical element according to Claim 9, wherein A of formula (I) is $(Bi_{0.5}Na_{0.5})TiO_3$ and B of formula (I) is $(Bi_{0.5}K_{0.5})TiO_3$, and preferably wherein $C_1$ and/or $C_2$ of formula (I) are selected from $SrHfO_3$, $SrZrO_3$, $Bi(Mg_{0.5}Ti_{0.5})O_3$, $Bi(Zn_{0.5}Ti_{0.5})O_3$, $Bi(Ni_{0.5}Ti_{0.5})O_3$, $KNbO_3$, $NaNbO_3$, $(K_{0.5}Na_{0.5})NbO_3$, $(Bi_{0.5}Li_{0.5})TiO_3$, $(Bi_{0.5}Na_{0.5})HfO_3$ and $(Bi_{0.5}K_{0.5})HfO_3$.

11. The electrical element according to Claim 9 or Claim 10, wherein the solid solution ceramic material has the formula (Ia):

$$(Ia): \qquad x(Bi_{0.5}Na_{0.5})TiO_3\text{-}y(Bi_{0.5}K_{0.5})TiO_3\text{-}z_1SrHfO_3\text{-}z_2SrZrO_3;$$

wherein $x+y+z_1+z_2 = 1$; $x, y \neq 0$; $(z_1 + z_2) > 0$.

12. The electrical element according to any one of the preceding claims, wherein the ceramic member further comprises a third layer of ceramic material (08), which is as defined for the first layer of ceramic material (06) in any one of the preceding claims, wherein the second layer of ceramic material (04) interposes the first (06) and third (08) layers of ceramic material in the ceramic member.

13. An electrical component comprising at least one electrical element according to any one of Claims 1 to 12 and further comprising a substrate layer (10) upon which the at least one electrical element is arranged and which is an actuator component for use in a droplet deposition apparatus.

14. A droplet deposition head comprising an actuator component according to Claim 13.

15. Use of a ceramic material having a proportion above 50 vol.% of a perovskite crystal structure doped with: I) one or more transition metal ions capable of Jahn-Teller distortion of the perovskite crystal structure of the ceramic material and/or II) one or more non-transition metal ions which have a lower oxidation state and/or one or more transition metal ions which preferentially undergo reduction, compared to the B-site cation of the perovskite crystal structure of the ceramic material, for increasing the median lifetime of an electrical element by incorporating the doped ceramic material as a layer (06) in a multilayer thin film ceramic member which is disposed adjacent first (01) and second (02) electrodes of the electrical element according to the independent claim 1 such that there are no additional layers of material located between the layer of doped ceramic material (06) of the multilayer thin film ceramic member and the first (01) and second (02) electrodes, and such that a potential difference is established between the first (01) and second (02) electrodes and through the thin film ceramic member.

**Patentansprüche**

1. Ein elektrisches Element zur Verwendung in mikroelektromechanischen Systemen, das Folgendes beinhaltet:

   i) ein Dünnfilmkeramikteil, das aus einer Vielzahl von Schichten von Keramikmaterial (04, 06, 08) mit einem Anteil von mehr als 50 Vol.-% einer Perowskit-Phase gebildet ist, wobei das genannte Dünnfilmkeramikteil eine erste Seite und eine gegenüberliegende zweite Seite aufweist, die in einer Dickerichtung beabstandet sind;
   ii) erste (01) und zweite (02) Elektroden, die angrenzend an das Dünnfilmkeramikteil angeordnet sind,

   wobei relativ zueinander eine von der ersten oder zweiten (01, 02) Elektrode eine Elektrode mit höherem Potential ist und die andere von der ersten und zweiten Elektrode (01, 02) eine Elektrode mit niedrigerem Potential ist, sodass während des Betriebs ein Potentialunterschied zwischen der ersten und zweiten Elektrode und durch das Dünnfilmkeramikteil angelegt wird;
   wobei das Dünnfilmkeramikteil Folgendes beinhaltet:

   eine erste Schicht von Keramikmaterial (06), dotiert mit:

   I) einem oder mehreren Übergangsmetallionen, die zur Jahn-Teller-Verzerrung der Perowskit-Kristallstruktur des Keramikmaterials fähig sind, und/oder
   II) einem oder mehreren Nicht-Übergangsmetallionen, die eine niedrigere Oxidationszahl aufweisen, und/oder einem oder mehreren Übergangsmetallionen, die bevorzugt eine Reduktion durchlaufen, verglichen mit dem B-Platz-Kation der Perowskit-Kristallstruktur des Keramikmaterials; und

   eine zweite Schicht von Keramikmaterial (04), die nicht mit einem von dem einen oder den mehreren Metallionen, wie für die erste Schicht von Keramikmaterial (06) definiert, dotiert ist;
   **dadurch gekennzeichnet, dass** sich die genannte erste Schicht von Keramikmaterial (06) über der Dicke des Dünnfilmkeramikteils befindet, um somit Folgendes zu sein:

   a) angrenzend an und in Kontakt mit beiden von der ersten (01) und zweiten (02) Elektrode, sodass sich keine zusätzlichen Schichten von Material zwischen der ersten Schicht von Keramikmaterial (06) und der ersten (01) und zweiten (02) Elektrode befinden, wobei die erste (01) und zweite (02) Elektrode beide angrenzend an eine von der ersten oder zweiten Seite des Dünnfilmkeramikteils angeordnet sind; oder
   b) angrenzend an und in Kontakt mit der einen von der ersten (01) oder zweiten (02) Elektrode, die die Elektrode mit niedrigerem Potential ist, sodass sich keine zusätzlichen Schichten von Material zwischen der ersten Schicht von Keramikmaterial (06) und der einen von der ersten (01) oder zweiten (02) Elektrode befinden, die die Elektrode mit niedrigerem Potential ist, wobei das Dünnfilmkeramikteil zwischen der ersten (01) und zweiten (02) Elektrode eingefügt ist.

2. Elektrisches Element nach Anspruch 1, wobei die Dicke der genannten ersten Schicht von Keramikmaterial (06) von 1% bis 10% der Gesamtdicke des Dünnfilmkeramikteils, bevorzugt von 2% bis 8% der Gesamtdicke des Dünnfilmkeramikteils, bevorzugter von 3% bis 5% der Gesamtdicke des Dünnfilmkeramikteils, beträgt.

3. Elektrisches Element nach Anspruch 1 oder Anspruch 2, wobei die Gesamtkonzentration des einen oder der mehreren Metallionen nach I) und II) in der ersten Schicht von Keramikmaterial (06) von 0,1 bis 10 At.-%, bevorzugt von 0,5 bis 5 At.-%, bevorzugter von 1 bis 3 At.-%, am bevorzugtesten von 1,5 bis 2,5 At.-% beträgt.

4. Elektrisches Element nach einem der vorhergehenden Ansprüche, wobei die erste Schicht von Keramikmaterial (06) mit einem oder mehreren Ionen dotiert ist, die ausgewählt sind aus: i) Ionen von Ag, Co, Cu, Mn, Re und Kombinationen davon; oder ii) Ionen von Co, Cr, Cu, Fe, Mn, Mo, Ni, V und Kombinationen davon.

5. Elektrisches Element nach einem der vorhergehenden Ansprüche, wobei die erste Schicht von Keramikmaterial (06) ein oder mehrere Mn-Ionen als Dotierungsmittel beinhaltet.

6. Elektrisches Element nach einem der vorhergehenden Ansprüche, wobei das Keramikmaterial Blei-, Titan-, Zirkonium-, Niob- und/oder Zinkionen beinhaltet, wobei das Keramikmaterial bevorzugt aus $Pb[Zr_xTi_{1-x}]O_3$ ($0 \leq x \leq 1$) und/oder $Pb[(Mg_{1/3}Nb_{2/3})_xTi_{1-x}]O_3$ ($0 < x < 0,9$) ausgewählt ist.

7. Elektrisches Element nach einem der Ansprüche 1 bis 5, wobei das Keramikmaterial bleifrei ist und Bismut-, Natrium- und/oder Kaliumionen enthält, wobei das Keramikmaterial bevorzugt aus einem oder mehreren von $(Bi_{0,5}Na_{0,5})TiO_3$, $(Bi_{0,5}K_{0,5})TiO_3$, $Bi(Mg_{0,5}Ti_{0,5})O_3$, $(K_{0,5}Na_{0,5})NbO_3$, $BiFeO_3$ und Mischkristallen, die Kombinationen davon beinhalten, ausgewählt ist.

8. Elektrisches Element nach einem der vorhergehenden Ansprüche, wobei das Keramikmaterial von mindestens der ersten Schicht von Keramikmaterial (06), bevorzugt von allen Schichten des Keramikmaterials, ein oder mehrere Titanionen beinhaltet, die den B-Platz der Perowskit-Kristallstruktur besetzen.

9. Elektrisches Element nach einem der Ansprüche 1 bis 5, 7 und 8, wobei das Keramikmaterial ein Mischkristall der Formel (I) unten ist:

$$(I): \qquad xA\text{-}yB\text{-}z_1C_1\text{-}Z_2C_2$$

wobei A eine erste bismutbasierte Perowskit-Komponente ist; B eine zweite bismutbasierte Perowskit-Komponente ist; $C_1$ und $C_2$ Dotiermittel-Perowskit-Komponenten sind; und wobei: $x+y+z_1+z_2 = 1$; $x, y \neq 0$; $(z_1 + z_2) \geq 0$.

10. Elektrisches Element nach Anspruch 9, wobei A der Formel (I) $(Bi_{0,5}Na_{0,5})TiO_3$ ist und B der Formel (I) $(Bi_{0,5}K_{0,5})TiO_3$ ist und wobei $C_1$ und/oder $C_2$ der Formel (I) bevorzugt aus $SrHfO_3$, $SrZrO_3$, $Bi(Mg_{0,5}Ti_{0,5})O_3$, $Bi(Zn_{0,5}Ti_{0,5})O_3$, $Bi(Ni_{0,5}Ti_{0,5})O_3$, $KNbO_3$, $NaNbO_3$, $(K_{0,5}Na_{0,5})NbO_3$, $(Bi_{0,5}Li_{0,5})TiO_3$, $(Bi_{0,5}Na_{0,5})HfO_3$ und $(Bi_{0,5}K_{0,5})HfO_3$ ausgewählt sind.

11. Elektrisches Element nach Anspruch 9 oder Anspruch 10, wobei das Mischkristall-Keramikmaterial die folgende Formel (Ia) aufweist:

$$(Ia): \qquad x(Bi_{0,5}Na_{0,5})TiO_3\text{-}y(Bi_{0,5}K_{0,5})TiO_3\text{-}z_1SrHfO_3\text{-}z_2SrZrO_3;$$

wobei $x+y+z_1+z_2 = 1$; $x, y \neq 0$; $(z_1 + z_2) \geq 0$.

12. Elektrisches Element nach einem der vorhergehenden Ansprüche, wobei das Keramikteil ferner eine dritte Schicht von Keramikmaterial (08) beinhaltet, die wie für die erste Schicht von Keramikmaterial (06) in einem der vorhergehenden Ansprüche definiert ist, wobei die zweite Schicht von Keramikmaterial (04) zwischen der ersten (06) und dritten (08) Schicht von Keramikmaterial in dem Keramikteil liegt.

13. Eine elektrische Komponente, die mindestens ein elektrisches Element nach einem der Ansprüche 1 bis 12 beinhaltet und ferner eine Substratschicht (10) beinhaltet, auf der das mindestens eine elektrische Element angeordnet ist, und die eine Aktuatorkomponente zur Verwendung in einer Tröpfchenabscheidevorrichtung ist.

14. Eine Tröpfchenabscheidekopf, der eine Aktuatorkomponente nach Anspruch 13 beinhaltet.

15. Verwendung eines Keramikmaterials mit einem Anteil von mehr als 50 Vol.-% einer Perowskit-Kristallstruktur, das dotiert ist mit: I) einem oder mehreren Übergangsmetallionen, die zur Jahn-Teller-Verzerrung der Perowskit-Kristallstruktur des Keramikmaterials fähig sind, und/oder II) einem oder mehreren Nicht-Übergangsmetallionen, die eine niedrigere Oxidationszahl aufweisen, und/oder einem oder mehreren Übergangsmetallionen, die bevorzugt eine Reduktion durchlaufen, verglichen mit dem B-Platz-Kation der Perowskit-Kristallstruktur des Keramikmaterials, zum Erhöhen der medianen Lebensdauer eines elektrischen Elements durch Einbau des dotierten Keramikmaterials als eine Schicht (06) in einem mehrschichtigen Dünnfilmkeramikteil, die angrenzend an eine erste (01) und zweite (02) Elektrode des elektrischen Elements nach dem unabhängigen Anspruch 1 angeordnet ist, sodass sich keine zusätzlichen Schichten von Material zwischen der Schicht von dotiertem Keramikmaterial (06) des mehrschichtigen Dünnfilmkeramikteils und der ersten (01) und zweiten (02) Elektrode befinden und sodass ein Potentialunterschied zwischen der ersten (01) und zweiten (02) Elektrode und durch das Dünnfilmkeramikteil angelegt wird.

**Revendications**

1. Élément électrique destiné à une utilisation dans des systèmes microélectromécaniques comprenant :

   i) un élément céramique à couche mince formé d'une pluralité de couches de matériau céramique (04, 06, 08) ayant une proportion supérieure à 50 % en volume d'une phase pérovskite, ledit élément céramique à couche mince ayant un premier côté et un deuxième côté opposé espacés dans la direction de l'épaisseur ;
   ii) une première électrode (01) et une deuxième électrode (02) disposées de façon adjacente à l'élément céramique à couche mince

   dans lequel, l'une par rapport à l'autre, une de la première ou de la deuxième électrode (01, 02) est une électrode à potentiel plus élevé et l'autre des première et deuxième électrodes (01, 02) est une électrode à potentiel inférieur, de telle sorte qu'une différence de potentiel soit établie entre les première et deuxième électrodes et à travers l'élément céramique à couche mince en cours de fonctionnement ;
   dans lequel l'élément céramique à couche mince comprend :

   une première couche de matériau céramique (06) dopée avec :

   I) un ou plusieurs ions métaux de transition capables de causer une distorsion Jahn-Teller de la structure cristalline pérovskite du matériau céramique et/ou
   II) un ou plusieurs ions non-métaux de transition qui ont un état d'oxydation inférieur et/ou un ou plusieurs ions métaux de transition qui subissent préférentiellement une réduction, par rapport au cation du site B de la structure cristalline pérovskite du matériau céramique ; et

   une deuxième couche de matériau céramique (04) non dopée avec n'importe lequel des un ou plusieurs ions métalliques telle que définie pour la première couche de matériau céramique (06) ;
   **caractérisé en ce que** ladite première couche de matériau céramique (06) est située, sur l'épaisseur de l'élément céramique à couche mince, de façon à être :

   a) adjacente à et en contact avec la première électrode (01) ainsi que la deuxième électrode (02) de telle sorte qu'il n'y ait pas de couches supplémentaires de matériau situées entre la première couche de matériau céramique (06) et les première (01) et deuxième (02) électrodes, les première (01) et deuxième (02) électrodes étant toutes deux disposées de façon adjacente à l'un du premier côté ou du deuxième côté de l'élément céramique à couche mince ; ou
   b) adjacente à et en contact avec celle de la première électrode (01) ou de la deuxième électrode (02) qui est l'électrode à potentiel inférieur de telle sorte qu'il n'y ait pas de couches supplémentaires de matériau situées entre la première couche de matériau céramique (06) et celle de la première (01) ou de la deuxième (02) électrode qui est l'électrode à potentiel inférieur, les première (01) et deuxième (02) électrodes étant interposées par l'élément céramique à couche mince.

2. Élément électrique selon la revendication 1, dans lequel l'épaisseur de ladite première couche de matériau céramique (06) est de 1 % à 10 % de l'épaisseur totale de l'élément céramique à couche mince, préférablement de 2 % à 8 % de l'épaisseur totale de l'élément céramique à couche mince, plus préférablement de 3 % à 5 % de l'épaisseur totale de l'élément céramique à couche mince.

3. Élément électrique selon la revendication 1 ou la revendication 2, dans lequel la concentration totale des un ou plusieurs ions métalliques selon I) et II) dans la première couche de matériau céramique (06) est de 0,1 à 10 %a, préférablement de 0,5 à 5 %a, plus préférablement de 1 à 3 %a, idéalement de 1,5 à 2,5 %a.

4. Élément électrique selon l'une quelconque des revendications précédentes, dans lequel la première couche de matériau céramique (06) est dopée avec un ou plusieurs ions sélectionnés parmi : i) des ions Ag, Co, Cu, Mn, Re et des combinaisons de ceux-ci ; ou ii) des ions Co, Cr, Cu, Fe, Mn, Mo, Ni, V et des combinaisons de ceux-ci.

5. Élément électrique selon l'une quelconque des revendications précédentes, dans lequel la première couche de matériau céramique (06) comprend un ou plusieurs ions Mn comme dopant.

6. Élément électrique selon l'une quelconque des revendications précédentes, dans lequel le matériau céramique comprend des ions plomb, titane, zirconium, niobium et/ou zinc, préférablement dans lequel le matériau céramique est sélectionné parmi $Pb[Zr_xTi_{1-x}]O_3$ ($0 \leq x \leq 1$) et/ou $Pb[(Mg_{1/3}Nb_{2/3})_xTi_{1-x}]O_3$ ($0 < x < 0,9$).

7. Élément électrique selon l'une quelconque des revendications 1 à 5, dans lequel le matériau céramique est exempt de plomb et contient des ions bismuth, sodium et/ou potassium, préférablement dans lequel le matériau céramique est sélectionné parmi un ou plusieurs de $(Bi_{0,5}Na_{0,5})TiO_3$, $(Bi_{0,5}K_{0,5})TiO_3$, $Bi(Mg_{0,5}Ti_{0,5})O_3$, $(K_{0,5}Na_{0,5})NbO_3$, $BiFeO_3$ et des solutions solides comprenant des combinaisons de ceux-ci.

8. Élément électrique selon l'une quelconque des revendications précédentes, dans lequel le matériau céramique d'au moins la première couche de matériau céramique (06), préférablement de toutes les couches du matériau céramique, comprend un ou plusieurs ions titane occupant le site B de la structure cristalline pérovskite.

9. Élément électrique selon l'une quelconque des revendications 1 à 5, 7 et 8, dans lequel le matériau céramique est une solution solide selon la formule (I) ci-dessous :

$$(I) : \qquad xA\text{-}yB\text{-}z_1C_1\text{-}z_2C_2$$

dans laquelle A est un premier composant pérovskite à base de bismuth ; B est un deuxième composant pérovskite à base de bismuth ; $C_1$ et $C_2$ sont des composants pérovskite dopants ; et dans laquelle $x + y + z_1 + z_2 = 1$ ; x, y $\neq$ 0 ; $(z_1 + z_2) \geq 0$.

10. Élément électrique selon la revendication 9, dans lequel l'élément A de la formule (I) est $(Bi_{0,5}Na_{0,5})TiO_3$ et l'élément B de la formule (I) est $(Bi_{0,5}K_{0,5})TiO_3$, et préférablement dans lequel les éléments $C_1$ et/ou $C_2$ de la formule (I) sont sélectionnés parmi $SrHfO_3$, $SrZrO_3$, $Bi(Mg_{0,5}Ti_{0,5})O_3$, $Bi(Zn_{0,5}Ti_{0,5})O_3$, $Bi(Ni_{0,5}Ti_{0,5})O_3$, $KNbO_3$, $NaNbO_3$, $(K_{0,5}Na_{0,5})NbO_3$, $(Bi_{0,5}Li_{0,5})TiO_3$, $(Bi_{0,5}Na_{0,5})HfO_3$ et $(Bi_{0,5}K_{0,5})HfO_3$.

11. Élément électrique selon la revendication 9 ou la revendication 10, dans lequel le matériau céramique en solution solide a la formule (Ia) :

$$(Ia) : \qquad x(Bi_{0,5}Na_{0,5})TiO_3\text{-}y(Bi_{0,5}K_{0,5})TiO_3\text{-}z_1SrHfO_3\text{-}z_2SrZrO_3 ;$$

dans laquelle $x + y + z_1 + z_2 = 1$ ; x, y $\neq$ 0 ; $(z_1 + z_2) \geq 0$.

12. Élément électrique selon l'une quelconque des revendications précédentes, dans lequel l'élément céramique comprend en outre une troisième couche de matériau céramique (08), qui est telle que définie pour la première couche de matériau céramique (06) dans l'une quelconque des revendications précédentes, dans lequel la deuxième couche de matériau céramique (04) interpose les première (06) et troisième (08) couches de matériau céramique dans l'élément céramique.

13. Composant électrique comprenant au moins un élément électrique selon l'une quelconque des revendications 1 à 12 et comprenant en outre une couche de substrat (10) sur laquelle l'au moins un élément électrique est disposé et qui est un composant actionneur destiné à une utilisation dans un appareil de dépôt de gouttelettes.

14. Tête de dépôt de gouttelettes comprenant un composant actionneur selon la revendication 13.

15. Utilisation d'un matériau céramique ayant une proportion supérieure à 50 % en volume d'une structure cristalline pérovskite dopée avec : I) un ou plusieurs ions métaux de transition capables de causer une distorsion Jahn-Teller de la structure cristalline pérovskite du matériau céramique et/ou II) un ou plusieurs ions nonmétaux de transition qui ont un état d'oxydation inférieur et/ou un ou plusieurs ions métaux de transition qui subissent préférentiellement une réduction, par rapport au cation du site B de la structure cristalline pérovskite du matériau céramique, pour augmenter la durée de vie médiane d'un élément électrique en incorporant le matériau céramique dopé sous la forme d'une couche (06) dans un élément céramique à couche mince multicouche qui est disposée de façon adjacente à la première électrode (01) et à la deuxième électrode (02) de l'élément électrique selon la revendication indépendante 1, de telle sorte qu'il n'y ait pas de couches supplémentaires de matériau situées entre la couche de matériau céramique dopé (06) de l'élément céramique à couche mince multicouche et les première (01) et deuxième (02) électrodes, de telle sorte qu'une différence de potentiel soit établie entre les première (01) et deuxième (02) électrodes et à travers l'élément céramique à couche mince.

**FIGURE 1:**

01
04
06
02
10
+
−

**FIGURE 2:**

01
06
04
02
10
−
+

**FIGURE 3:**

01
08
04
06
02
10
+
−

**FIGURE 4:**

**FIGURE 5:**

**FIGURE 6:**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170021624 A
- US 8179027 B
- US 2006055288 A
- GB 2532106 A
- EP 3220431 A

**Non-patent literature cited in the description**

- **LUFASO, MICHAEL W. ; WOODWARD, PATRICK M.** Jahn-Teller Distortions, Cation Ordering and Octahedral Tilting in Perovskites. *Chemistry Faculty Publications.,* 2004, vol. 3